# EUROPÄISCHE PATENTSCHRIFT

(11) **EP 4 384 392 B1**
(45) Veröffentlichungstag und Bekanntmachung des Hinweises auf die Patenterteilung: **19.03.2025**
(21) Anmeldenummer: 21765595.0
(22) Anmeldetag: 12.08.2021
(51) Int. Cl.: B32B 15/08, B32B 15/20, B32B 27/28, C08G 77/48, C08G 77/50, C08G 77/52, H05K 1/05

(54) **METALLPLATTIERTE SCHICHTSTOFFE ENTHALTEND POLYORGANOSILOXANE**
METAL-PLATED LAMINATES CONTAINING POLYORGANOSILOXANES
STRATIFIÉS MÉTALLISÉS CONTENANT DES POLYORGANOSILOXANES

(43) Veröffentlichungstag der Anmeldung: 19.06.2024
(73) Patentinhaber: Wacker Chemie AG, 81671 München (DE)
(72) Erfinder: SANDMEYER, Frank, 84508 Burgkirchen (DE)
(74) Vertreter: Wimmer, Andreas
(86) Internationale Anmeldenummer: PCT/EP2021/072479
(87) Internationale Veröffentlichungsnummer: WO 2023/016649

(56) Entgegenhaltungen:
- EP-A1- 3 239 243
- WO-A1-2014/100656

## Beschreibung

Die vorliegende Erfindung betrifft metallplattierte Schichtstoffe, welche vernetzungsfähige Organopolysiloxanverbindungen enthalten.

### Stand der Technik:

Kupferkaschierte Elektrolaminate bestehen nach DIN 40802 Blatt 2 aus einem ein- oder zweiseitig mit Elektrolyt-Kupferfolie mit einem Reinheitsgrad von mindestens 99,5 % kaschierten Schichtpressstoff. Dabei dient der Schichtstoff als Träger- und isolationsmaterial, die Kupferschicht zur Herstellung der Leiterbahnen. Bei Elektrolaminaten haben drei Produkte Bedeutung erlangt. Bei diesen besteht der Schichtstoff aus Hartpapier, Epoxidhartpapier oder Epoxyharz-Glasgewebe.

Immer häufiger, vor allem in der Fernmeldetechnik, wo mit höheren Frequenzen gearbeitet wird, wird das Epoxyharz-Glasgewebe, trotz des höheren Preises gegenüber dem Hartpapier, verwendet. Die Vorteile dieses Elektrolaminats sind hohe mechanische Festigkeit, bessere elektrische Werte bei Feuchtigkeitseinwirkung und die geringen dielektrischen Verluste bei hohen Frequenzen.

Die Fertigung der Elektrolaminate läuft wie folgt ab. Die Papier- oder Gewebebahnen für den Schichtstoff, beispielsweise Glasfaserbahnen werden mit Harz, das als Bindemittel wirkt, imprägniert. Gebräuchlich sind dafür Epoxypolyester, Phenol oder Melamin. Anschließend werden die imprägnierten Bahnen getrocknet, wobei das Harz bis zum gewünschten Grad vorkondensiert wird.

Mit der fortschreitenden Erschließung der Hochfrequenztechnologie in den GHz Bereich hinein für die drahtlose Kommunikation steigt der Bedarf an Materialien, die zu ihrer Realisierung geeignet sind. Dies betrifft alle Bereiche von Materialien wie Kupferfolien, Bindemittel, Glasfasern, etc. Bei den Bindemitteln sind die klassischer Weise für die Herstellung von kupferkaschierten Laminaten bzw. zur Platinenherstellung verwendeten Epoxidharze aufgrund zu hoher dielektrischer Verlustfaktoren für GHz Anwendungen nicht mehr einsetzbar. Polytetrafluorethylen, das einen sehr niedrigen dielektrischen Verlustfaktor besitzt und für Hochfrequenzanwendungen unter diesem Aspekt gut einsetzbar ist, besitzt andere Nachteile, insbesondere die schlechte Verarbeitbarkeit und schlechte Haftungseigenschaften, die eine Alternative wünschenswert machen. Polyphenylenether, Kohlenwasserstoffharze und Bismaleimide sowie Varianten wie beispielsweise Bismaleimidtriazinharze und Kombinationen der genannten organischen Polymere, werden derzeit als Bindemittel für dieses Anwendungsgebiet intensiv beforscht, da sie niedrige dielektrische Verlustfaktoren mit guten mechanischen und thermischen Eigenschaften und Wasserabweisung verbinden. Polyorganosiloxane besitzen exzellente Hitzefestigkeit, Bewitterungsstabilität und Hydrophobie, sind flammfest und verfügen über niedrige dielektrische Verlustfaktoren.

Diese Eigenschaftsprofile qualifizieren sowohl die Polyphenylenether, Bismaleimide, Bismaleimidtriazin und Kohlenwasserstoffharze als auch die Polyorganosiloxane für den Einsatz als Bindemittel für die Herstellung von hochfrequenzfähigen kupferkaschierten Laminaten und Bauteilen, wie Platinen und Antennen.

Daher ist es naheliegend Siliconharze sowohl als Bindemittel für diese Hochfrequenzanwendungen einzusetzen als auch die positiven Eigenschaften der Silicone mit denen der genannten organischen Polymeren zu vereinen, um ihre Leistungsfähigkeit symbiotisch zu erhöhen. Entsprechende Versuche sind bereits im Stand der Technik dokumentiert.

Überwiegend sind in Polyorganosiloxanen benachbarte Siliziumatome über Sauerstoffatome miteinander verbunden. Grundsätzlich sind jedoch auch andere Arten bekannt, wie benachbarte Siliziumatome miteinander verbunden sein können, wie beispielsweise durch organische Reste verbrückte Einheiten.

Organische Reste, die benachbarte Siliziumatome verbrücken entstehen beispielsweise stets als Ergebnis einer Hydrosilylierungsreaktion, bei der eine Si-H-Gruppe an einen ungesättigten siliziumgebundenen organischen Rest addiert. Solche Reaktionen sind vor allem bekannt zur Härtung einer Zubereitung, die diese beiden Arten funktioneller Gruppen enthält, nach der Anwendung der Zubereitung zur dauerhaften Fixierung eines erreichten Applikationsergebnisses, siehe beispielsweise US 2018/0370189. Sie können auch zur Herstellung von benachbarte Siliziumatome verbrückende organische Reste enthaltenden Polyorganosiloxanen Anwendung finden, bei der eine weiterverarbeitbare Spezies entsteht. In diesen Fällen bleiben die vorgebildeten Siliconstrukturen und Zusammensetzungen erhalten und es entstehen stets blockcopolymere Strukturen unter Erhalt der Ausgangsstrukturen als sie aufbauende Blocksegmente. Eine statistische Verteilung der zwei Siliziumatome verbrückenden organischen Substituenten ist auf diese Weise nicht möglich. Zudem ist man hinsichtlich der Zahl der verbrückenden Einheiten beschränkt durch die Zahl der terminalen funktionellen Gruppen. Insbesondere wenn diese Vorgehensweise gewählt wird, um einen einmal erreichten Endzustand zu fixieren, ist dabei zu beachten, dass durch die Härtungsreaktion ein Volumenschrumpf einsetzt, der zu Spannungen in der gehärteten Matrix führt und die mechanische Leistungsfähigkeit limitiert oder herabsetzt. Um beliebig viele solcher verbrückenden Einheiten in eine Organopolysiloxan-struktur einbringen zu können, falls diese beispielsweise eine besondere Funktion für eine gewählte Anwendung aufweisen, ist dieser Weg daher nicht geeignet und beispielsweise für die Erfindung wie sie in US 2018/0370189 dargelegt ist begrenzend.

US 10316148 lehrt Organopolysiloxane der Formel (R¹SiO_{3/2})ₐ(XR²₂SiO_{1/2})_{b}(O_{1/2}SiR²₂YR²₂SiO_{1/2)})_{c}, wobei R¹ und R² jeweils unabhängig voneinander C₁-C₂₀ Alkylgruppen, C₆-C₂₀ Arylgruppen oder C₇-C₂₀ Aralkylgruppen sind. Ist X eine C₂-C₁₂ Alkandiylgruppe oder ein linearer 2 - 7 Si-Einheiten umfassender, Si-H funktioneller Siloxanrest mit einer verbrückenden C₂-C₁₂ Alkandiylgruppe, dann ist Y eine lineare verbrückende Siloxangruppe mit 2 bis 7 Siloxaneinheiten, wobei Y jeweils über eine verbrückende C₂-C₁₂ Alkandiylgruppe in das erfindungsgemäße Organopolysiloxan eingebunden ist.

Bedeutet X eine C₂-C₁₂ Alkandiylgruppe oder einen aus zwei Siloxaneinheiten bestehenden Si-H terminierten Siloxanrest, in dem die beiden Siloxaneinheiten durch einen verbrückenden Silphenylenrest verbunden sind, bedeutet Y einen zwei Siloxaneinheiten umfassenden Siloxanrest, in dem die beiden Siloxaneinheiten durch einen verbrückenden Silphenylenrest miteinander verbunden sind und der Rest Y jeweils über eine verbrückende C₂-C₁₂ Alkandiylgruppe in das erfindungsgemäße Organopolysiloxan eingebunden ist.

X und Y sind so gewählt, dass sie zur Ausbildung ausschließlich linearer Strukturen führen, so dass grundsätzlich Blockcopolymere Polyorganosiloxane vorliegen, in denen die (R¹SiO_{3/2})-Einheiten den dreidimensionalen Siliconharzblock bilden und die (XR²₂SiO_{1/2})_{b}(O_{1/2}SiR²₂YR²₂SiO_{1/2)})_{c}-Einheiten den linearen Block. Ungesättigte organische Reste, die durch eine radikalische Reaktion zur Reaktion gebracht werden könnten, sind nicht vorhanden. Diese werden bei der Bildungsreaktion der erfindungsgemäßen Polyorganosiloxane durch Hydrosilylierung, bei der die Si-H-Gruppen im Überschuss eingesetzt werden vollständig verbraucht, so dass Si-H-terminierte Polyorganosiloxane entstehen.
a bedeutet eine Zahl von 0,65 bis 0,9, b ist eine Zahl von 0,1 bis 0,35 und c ist eine Zahl von 0 bis 0,1, wobei a+b+c=1.

Die erfindungsgemäßen Organopolysiloxane dieser Erfindung werden hergestellt durch eine Hydrosilylierungsreaktion eines Polyorganosiloxans (R¹SiO_{3/2})_{d}(R⁵R²₂SiO_{1/2})ₑ wobei R⁵ eine olefinisch ungesättigte C2 - C12 Alkenylgruppe ist, d eine Zahl von 0,65 bis 0,9 und e eine Zahl von 0,1 - 0,35 ist mit einem linearen Si-H terminalen Polyorganosiloxan der Formel HR³₂SiO(R³₂SiO)ₙSiR³₂H oder einem Disilylbenzol der Formel HR³₂Si-C₆H₄-SiR³₂H, wobei sowohl eine zweifache als auch eine nur einfache Hydrosilylierung der zweifach Si-H-terminierten Siloxankomponenten möglich ist.

Sowohl die alkandiylverbrückten als auch die phenylenverbrückten Baugruppen sind ausschließlich in lineare Segmente der Polysiloxanstruktur eingebettet, bei denen die durch die Alkandiylgruppe oder die durch die Phenylengruppe verbrückten Siliziumatome stets nur an ein weiteres Siliziumatom gebunden vorliegen und nicht Ausgangspunkt für eine Verzweigung durch Bindungen zu mehreren Siliziumatomen sind.

Die Polyorganosiloxane gemäß US 10316148 zeigen einen hohen Brechungsindex, hohe Transparenz und gute Verarbeitbarkeit für den Einsatz in optischen Halbleiterelementen. Aufgrund der Bildungsreaktion durch Hydrosilylierung enthalten sie Platin als Verunreinigung.

US 2015/0144987 lehrt hydrosilylierbare Zubereitungen aus alkenylfunktionellen dreidimensionalen Polyorganosiloxanen, linearen alkenylfunktionellen Polyorganosiloxanen, linearen Si-H terminalen Polyorganosiloxanen, die Silphenylengruppen enthalten, gegebenenfalls einer weiteren linearen Si-H terminierten Komponente, die keine Silphenyleneinheit enthält und einem Hydrosilylierungskatalysator. Nach der Härtung durch Hydrosilylierung besitzen die erfindungsgemäßen Zubereitungen dieser Erfindung wie die Polyorganosiloxane aus US 10316148 auch sowohl benachbarte Siliziumatome, die alkandiylverbrückt sind als auch solche die phenylenverbrückt sind. Dabei sind die phenylenverbrückten Silphenyleneinheiten stets lineare Polyorganosiloxansegmente, in denen die durch die Phenylengruppe verbrückten Siliziumatome durch eine Si-O-Si-Bindung stets nur an ein weiteres Siliziumatome gebunden vorliegen und nicht Ausgangspunkt für eine Verzweigung durch Bindungen zu mehreren Siliziumatomen sind. Aufgrund der Hydrosilylierungsreaktion enthalten auch diese Polyorganosiloxane Platin als Verunreinigung.

Die Zubereitungen besitzen hohe Abbe Zahlen, gute Farbtonbeständigkeit in optischen Halbleiterelementen und werden zur Verkapselung derselben verwendet.

US 6072016 lehrt lineare Polyorganosiloxane, die Silphenylengruppen enthalten und die über endständige kondensationsfähige Gruppen vernetzbar sind. Sie enthalten keine Si-H Funktionen oder aliphatisch ungesättigte Gruppen.

US 6252100 offenbart Verfahren zur Herstellung von linearen Organopolysiloxanen, die Struktureinheiten enthalten, in denen zwei R₂Si-Einheiten über einen bifunktionellen α, ω-Alkandiylrest mit 2 bis 18 C-Atomen miteinander verbunden sind.

US 6034225 beschreibt lineare Organopolysiloxane mit aliphatisch ungesättigten Resten, die unter anderem mindestens eine Einheit der Formel O_{1/2}R₂SiOₓYRSiO_{2/2} enthalten, die gegebenenfalls eine Verzweigung enthält, sowie gegebenenfalls auch O_{1/2}R₂SiOₓYR₂SiO_{1/2}-Einheiten, die wiederum rein linear wäre. Im Falle x = 0 sind entweder eine Dialkyl- mit einer Alkylsiloxyeinheit, die mit zwei benachbarten Siliziumatomen über Sauerstoffatome verbunden ist oder/und zwei Dialkylsiloxyeinheiten miteinander über den Spacer Y verbunden. Y ist ein bifunktioneller Rest der Formel - (CR³₂)ₙCHR³-, mit R³ gleich einem aliphatisch gesättigten Kohlenwasserstoffrest oder gleich H und n gleich Null oder eine ganze Zahl von 1 bis 7. Organopolysiloxanverbindungen mit Aktivwasserstoff in Form von H-Si-Verbindungen sowie Kohlenwasserstoffbrücken zwischen zwei Si-Atomen sind beschrieben in EP 786 463 Al sowie JP 06,107,949 und US 4849491.

US 20100137544 lehrt Polyorganosiloxane, die pro Molekül mindestens eine Struktureinheit der allgemeinen Formel (I): O_{3-a/2}RₐSi-Y(SiRₐO_{3-a/2})_{b} enthalten, wobei R gleich oder verschieden sein kann und einen einwertigen Si-C gebundenen organischen Rest mit 1 bis 30 C-Atomen, der ein oder mehrere N und/oder O-Atome enthalten kann, bedeutet; Y einen zwei- bis zwölfwertigen org. Rest mit 1 bis 30 C-Atomen, der ein oder mehrere O-Atome enthalten kann und der ungesättigt sein kann, bedeutet; a 0 oder 1 ist und b eine ganze Zahl von 1 bis 11 ist.

Das Dokument WO 2014/100656 A1 offenbart die Herstellung eines Organopolysiloxans der vorliegenden Formel (I). Dieses Polymer wird zur Herstellung von metallplatierten Schichtstoffen verwendet.

### Aufgabenstellung:

Die vorliegende Erfindung ist der Aufgabe gewidmet Polyorganosiloxane bereitzustellen, die unter den Bedingungen der radikalischen Polymerisation dreidimensional vernetzbar sind und die zur Verwendung als Bindemittel für Hochfrequenzanwendungen geeignete dielektrische Eigenschaften besitzen. Dazu gehört, dass sie als reines Bindemittel bei 10 GHz einen dielektrischen Verlustfaktor von nicht mehr 0,0040 besitzen, gegebenenfalls vorhandene den dielektrischen Verlustfaktor senkende Füllstoffe gut benetzen und die Herstellung klebfreier Prepregs gestatten.

Die vorliegende Erfindung betrifft metallplattierte Schichtstoffe, welche enthalten vernetzungsfähige, d.h. härtbaren Organopolysiloxanverbindungen der Formel (I)

[O_{3-a/2}RₐS1-Y(SiRₐO_{3-a/2})_{b}]_{c}(R¹SiO_{3/2})_{d}(R²₂SiO_{2/2})ₑ(R³₃SiO_{1/2})_{f}(SiO_{4/2})_{g} (I)

wobei R gleich oder verschieden sein kann und entweder einen Wasserstoffrest oder einen einwertigen Si-C gebundenen, gegebenenfalls mit Heteroatomen substituierten organischen Kohlenwasserstoffrest mit 1 bis 18 C-Atomen bedeutet, der auch ein ungesättigter Kohlenwasserstoffrest sein kann,
Y einen zwei- bis zwölfbindigen gegebenenfalls mit Heteroatomen substituierten organischen Rest mit 1 bis 24 C-Atomen bedeutet, wobei der Rest Y stets durch eine Si-C-Bindung an die Siliziumatome gebunden vorliegt, die durch den Rest Y miteinander verbunden werden,
R¹ unabhängig voneinander einen Wasserstoffrest oder einen vorzugsweise Si-C-gebundenen ungesättigten C1 - C18 Kohlenwasserstoffrest bedeutet, der gegebenenfalls mit Heteroatomen substituiert sein kann, der gegebenenfalls auch über ein Sauerstoffatom an das Siliziumatom gebunden vorliegen kann, wobei die Reste R¹ ihre Bedeutung jeweils unabhängig voneinander annehmen können, so dass mehrere Reste R¹ in dem Organopolysiloxan gemäß Formel (I), verschiedene Reste aus der definierten Gruppe bedeuten können,
die Reste R² und R³ unabhängig voneinander einen Wasserstoffrest oder einen gegebenenfalls ungesättigten Si-C gebundenen C1 - C18 Kohlenwasserstoffrest, der gegebenenfalls mit Heteroatomen substituiert sein kann oder einen über ein Sauerstoffatom gebundenen C1 - C12 gegebenenfalls Heteroatome enthaltenden Kohlenwasserstoffrest bedeuten, wobei die Reste R² und die Reste R³ ihre Bedeutung jeweils unabhängig voneinander annehmen können, so dass mehrere Reste R² bzw. mehrere Reste R³, die am gleichen Siliziumatom gebunden vorliegen, verschiedene Reste aus der definierten Gruppe bedeuten können,
wobei bezogen auf alle Si-C-gebundenen Reste Y, R, R¹, R² und R³ als 100 mol-% mindestens 0,1 mol-%, bevorzugt mindestens 3 mol-%, besonders bevorzugt mindestens 5 mol-% insbesondere mindestens 7 mol-% aliphatisch, d.h. olefinisch oder acetylenisch ungesättigte Reste sein müssen,
a 0, 1 oder 2 ist, wobei die Indices a zu beiden Seiten der Gruppe Y ihre Bedeutung unabhängig voneinander annehmen können, so dass verschiedene a unabhängig voneinander verschiedene Werte innerhalb des angegebenen Wertebereiches bedeuten können,
b eine Zahl im Wert von 1 bis 11, vorzugsweise 1,
c einen Wert von 0,1 bis 0,99, vorzugsweise von 0,2 bis 0,98, besonders bevorzugt 0,25 bis 0,8, insbesondere von 0,3 bis 0,8,
d einen Wert von 0 bis 0,8, bevorzugt von 0,1 bis 0,7 besonders bevorzugt von 0,1 bis 0,6 insbesondere von 0,1 bis 0,5,
e einen Wert von 0 bis 0,5, vorzugsweise von 0 bis 0,2
f einen Wert von 0,01 bis 0,6 und
g einen Wert von 0 bis 0,2 bedeutet, wobei
c+d+e+f+g = 1 ist.

Die Organopolysiloxanverbindungen der Formel (I) dienen als Bindemittel und / oder als Haftvermittler für die metallplattierten Schichtstoffe. Die Organopolysiloxanverbindungen der Formel (I) werden vor der Anwendung der Schichtstoffe vernetzt. Die Schichtstoffe sind vorzugsweise metallkaschierte Schichtstoffe. Die Schichtstoffe werden vorzugsweise eingesetzt in elektronischen Bauteilen, vorzugsweise in Hochfrequenzanwendungen, ganz besonders solchen, die bei Frequenzen von 1 GHz und darüber betrieben werden.

Überraschender Weise wurde gefunden, dass hierfür geeignete ungesättigte organische funktionelle Gruppen tragende Polyorganosiloxane oder Zubereitungen derselben besonders gut geeignet sind, die neben regulären durch Sauerstoffatome miteinander verbundenen Siloxaneinheiten auch Baugruppen enthalten, in denen benachbarte Siliziumatome nicht durch Sauerstoffatome miteinander verbunden sind, sondern die durch beidseitig durch Si-C-Bindungen gebundene verbrückende Alkylen-, Aralkylen- oder Aryleneinheiten verbrückt sind, sofern gleichzeitig polare heteroatomsubstituierte Gruppen am Polyorganosiloxan vermieden, d.h. durch geeignete Maßnahmen nach Stand der Technik weitestgehend reduziert werden, einschließlich insbesondere Alkoxygruppen und Silanolgruppen.

Polare Gruppen wie Alkoxygruppen insbesondere mit kurzen Alkylgruppen und Silanolgruppen besitzen selbst höhere dielektrische Verlustfaktoren und tragen darüber hinaus zur Erhöhung des dielektrischen Verlustfaktors bei, indem sie Angriffspunkte für Feuchtigkeit bilden.

Da die Elektronegativitätsdifferenz zwischen Silizium und Sauerstoff gemäß der Elektronegativitätsskala von Allred und Rochow mit 1,76 um 1 größer ist als die Elektronegativitätsdifferenz zwischen Silizium und Kohlenstoff gemäß der gleichen Tabelle, besitzt die Si-C-Bindung eine geringere Polarität als die Si-O-Bindung. Es ist daher zu erwarten, dass der Ersatz von Si-O-Bindungen durch Si-C-Bindungen einen Beitrag zur Reduzierung der Gesamtpolarität von Organopolysiloxanen leistet und damit einen Beitrag zur Reduzierung des dielektrischen Verlustfaktors entsprechender Komponenten. Dieser Effekt ist umso ausgeprägter je mehr Si-O-Bindungen durch Si-C-Bindungen ersetzt werden können. Die Reduzierung der Polarität im Organopolysiloxangerüst beispielsweise durch die Einführung von Si-C-Bindungen anstelle von Si-O-Bindungen leistet damit einen erheblichen Beitrag zur breiten Verwendbarkeit von solchen Organopolysiloxanen.

Da Polydiorganosiloxane als Öle keinen Bindemittelcharakter besitzen, sind sie als Bindemittel für metallkaschierte Composite nicht geeignet. Konsequenterweise werden in US 2018/0370189 auch Siliconharze als Bindemittel eingesetzt und diese mit Siliconölen lediglich in ihrer Viskosität eingestellt und zu Blockcopolymeren gehärtet. Das eigentliche Bindemittel ist jedoch das Siliconharz, nicht das Siliconöl. Hinweise auf die gezielte Anpassung und Optimierung der verwendeten Siliconharze für die in US 2018/0370189 beschriebene Anwendung sind dort allerdings nicht enthalten, da die dazu bestehenden Möglichkeiten offenbar nicht erkannt wurden.

Die vorliegende Erfindung verbessert den Stand der Technik gemäß US 2018/0370189 und entwickelt ihn weiter, denn um den Effekt der reduzierten Polarität des Siloxangerüstes gezielt verwenden zu können, ist es nicht ausreichend benachbarte Siliziumatome verbrückende Si-C-gebundene organische Reste nur durch die Aushärtung gegebenenfalls vorhandener Si-H-Gruppen und Si-Olefin Gruppen durch eine Hydrosilylierung am Ende eines Applikationsvorganges entstehen zu lassen. Der damit verbundene Volumenschrumpf durch die Additionsreaktion gemäß US 2018/0370189 setzt der eigenschaftsbezogenen Anwendung dieser Option zu enge Grenzen.

Die Organopolysiloxanverbindungen der Formel (I) weisen bei 10 GHz einen dielektrischen Verlustfaktor von nicht mehr 0,0040 auf.

Die Organopolysiloxanverbindungen der Formel (I)umfassen im Rahmen der vorliegenden Erfindung sowohl polymere als auch oligomere Organosiloxane.

Insbesondere sind auch Strukturen der Formel (Ia) umfasst,

[O_{3-a/2}RₐSi-Y(SiRₐO_{3-a/2})_{b}]_{c}(R³₃SiO_{1/2})_{f} (Ia)

für die d, e und g jeweils 0 ist. Diese Grenzstruktur ist im erfindungsgemäßen Umfang enthalten und mit gemeint. Darin ist der Anteil an Si-C gebundenen verbrückenden organischen Resten besonders hoch und die Struktur wird praktisch nur noch durch die terminierenden Einheiten (R³₃SiO_{1/2})_{f} abgeschlossen. In einer bevorzugten Ausführungsform von (Ia) ist der Wert für a = 2. Alle Angaben für R, R³, a, b und c wie oben angegeben behalten auch für (Ia) ihre Gültigkeit.

Beispiele für R, R¹, R² und R³ sind gesättigte oder ungesättigte Kohlenwasserstoffreste, die aromatische oder aliphatische Doppelbindungen enthalten können, z. B. Alkylreste, wie der Methyl-, Ethyl-, n-Propyl-, iso-Propyl-, n-Butyl-, isoButyl-, tert.- Butyl-, n-Pentyl-, iso-Pentyl-, neo-Pentyl- und der tert.- Pentylrest, Hexylreste, wie der n-Hexylrest, Heptylreste, wie der n-Heptylrest, Octylreste, wie der n-Octylrest und iso- Octylreste, wie der 2, 2, 4-Trimethylpentyl- und der 2- Ethylhexylrest, Nonylreste, wie der n-Nonylrest, Decylreste, wie der n-Decylrest, Dodecylreste, wie der n-Dodecylrest, Tetradecylreste, wie der n-Tetradecylrest, Hexadecylreste, wie der n-Hexadecylrest und Octadecylreste, wie der n-Octadecylrest, Cycloalkylreste, wie Cyclopentyl-, Cyclohexyl- und 4-Ethylcyclohexylrest, Cycloheptylreste, Norbornylreste und Methylcyclohexylreste, Arylreste, wie der Phenyl-, Biphenyl-, Naphthyl- und Anthryl- und Phenanthrylrest; Alkaryl- reste, wie o-, m-, p-Tolylreste, Xylylreste und Ethylphenyl- reste; Aralkylreste, wie der Benzylrest, Alkenylreste, wie der 7-Octenyl-, 5-Hexenyl-, 3-Butenyl-, Allyl- und der Vinylrest sowie der alpha- und der β-Phenylethylrest.

Bevorzugte Heteroatome, die in den Resten R, R¹, R² und R³ enthalten sein können, sind Sauerstoffatome. Darüber hinaus sind auch Stickstoffatome, Phosphoratome, Schwefelatome und Halogenatome wie Chloratome und Fluoratome möglich.

Beispiele für bevorzugte Heteroatome enthaltende organische Reste R, R¹, R² und R³ sind Reste die Acryloyloxy-, bzw. Methacryloyloxyreste von Acrylsäure oder Methacrylsäure sowie den Acrylsäureestern oder Methacrylsäureestern von unverzweigten oder verzweigten Alkoholen mit 1 bis 15 C-Atomen enthalten. Bevorzugte solche Reste sind diejenigen, die sich aus Methylacrylat, Methylmethacrylat, Ethylacrylat, Ethylmethacrylat, Propylacrylat, Propylmethacrylat, n-Butylacrylat, n-Butylmethacrylat, iso-Butylacrylat, iso-Butylmethacrylat, t-Butylacrylat, t-Butylmethacrylat, 2-Ethylhexylacrylat und Norbornylacrylat ableiten. Besonders bevorzugt sind Methylacrylat, Methylmethacrylat, n-Butylacrylat, iso-Butylacrylat, t-Butylacrylat, 2-Ethylhexylacrylat, und Norbornylacrylat. Diese Reste sind vorzugsweise nicht direkt an das Siliziumatom gebunden, sondern sind über einen Kohlenwasserstoffspacer gebunden, der 1 bis 12 Kohlenstoffatome umfassen kann, wobei er vorzugsweise 1 oder 3 Kohlenstoffatome umfasst und außer den Heteroatomen, die im Acryloyloxy- bzw. Methacryloyloxyrest enthalten sind, keine weiteren Heteroatome umfasst.

Weitere bevorzugte Heteroatome umfassende Reste R, R¹, R² und R³ sind solche der Formel (II).

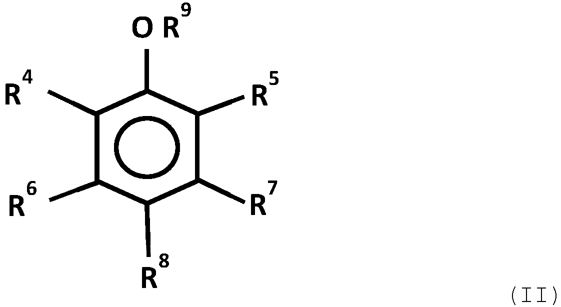

Vorzugsweise werden die Kohlenwasserstoffreste R, R¹, R² und R³ ausgewählt aus Methyl- Phenyl-, Vinyl-, Acryloyloxy- und Methacryloyloxyresten sowie den Acrylsäureestern oder Methacrylsäureestern von unverzweigten oder verzweigten Alkoholen mit 1 bis 15 C-Atomen.

In Formel (II) bedeuten R⁴, R⁵, R⁶, R⁷ R⁸ und R⁹ unabhängig voneinander ein Wasserstoffradikal, eine Kohlenwasserstoffgruppe oder eine mit Fremdatomen substituierte Kohlenwasserstoffgruppe, wobei stets mindestens einer der Reste R⁴, R⁵, R⁶, R⁷ oder R⁸ eine Kohlenwasserstoffgruppe bedeutet, die über eine Si-C oder eine Si-O-C-Bindung an das Siliziumatome gebunden vorliegt, wobei es bevorzugt ist, dass diese Kohlenwasserstoffgruppe, über die der Rest der Formel (II) an ein Siliziumatom gebunden ist, eine C3-Kohlenwasserstoffgruppe ist, die keine Heteroatome enthält. Alternativ kann der Rest R⁴, R⁵, R⁶, R⁷ oder R⁸ auch eine chemische Bindung sein, so dass der Rest der Formel (II) über diesen Rest, der eine chemische Bindung darstellt über eine Si-C-Bindung direkt an das Siliziumatom gebunden vorliegt.

Beispiele für Reste R⁴, R⁵, R⁶, R⁷, R⁸ oder R⁹ sind der Wasserstoffrest, gesättigte Kohlenwasserstoffreste wie der Methyl, Ethyl, n-Propyl, iso-Propyl, der primäre, sekundäre und tertiäre Butylrest, der Hydroxyethylrest, aromatische Reste wie der Phenylethylrest, der Phenylrest, der Benzylrest, der Methylphenylrest, der Dimethylphenylrest, der Ethylphenylrest heteroatomhaltige Reste wie der Hydroxymethylrest, der Carboxyethylrest, der Methoxycarbonylethylrest und der Cyanoethylrest und Acrylat- und Methacrylatreste, wie Methylacrylat, Methylmethacrylat, Ethylacrylat, Ethylmethacrylat, Propylacrylat, Propylmethacrylat, n-Butylacrylat, n-Butylmethacrylat, iso-Butylacrylat, iso-Butylmethacrylat, t-Butylacrylat, t-Butylmethacrylat, 2-Ethylhexylacrylat und Norbornylacrylat, olefinisch oder acetylenisch ungesättigte Kohlenwasserstoffreste.

Gegebenenfalls können die benachbarten Reste R⁴ und R⁶ sowie die benachbarten Reste R⁵ und R⁷ auch miteinander zu dem gleich cyclischen gesättigten oder ungesättigten Rest verbunden sein, so dass annelierte polycyclische Strukturen entstehen.

Beispiele für Phenolreste der Formel (II) sind der Phenolrest, der ortho-, meta- oder para-Cresolrest, 2,6-, 2,5-, 2,4- oder 3,5-Dimethylphenolrest, 2-Methyl-6-Phenylphenolrest, 2,6-Diphenylphenolrest, 2,6-Diethylphenolrest, 2-Methyl-6-ethylphenolrest, 2,3, 5-, 2,3,6- oder 2,4,6-Trimethylphenolrest, 3-Methyl-6-tertiär-Butylphenolrest, Thymolrest und 2-Methyl-6-allylphenolrest, die gegebenenfalls am Sauerstoffatom substituiert sein können.

Bevorzugte Beispiele für fluorhaltige Reste sind der Trifluorpropyl-, der Nonafluorhexyl- und der Heptadecafluoroctylrest.

Y ist vorzugsweise eine verbindende organische Einheit mit 1 bis 24 C-Atomen zwischen vorzugsweise zwei bis zwölf Siloxanyleinheiten. Bevorzugt ist Y zwei-, drei- oder vierwertig, insbesondere zweiwertig.

Bevorzugte verbrückende aromatische Reste Y sind solche der Formel (IIIa), (IIIb) und (IIIc) 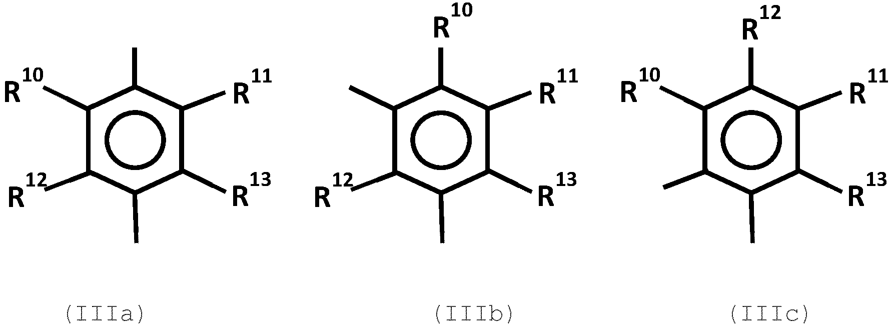 wobei die Reste R¹⁰, R¹¹, R¹² und R¹³ einen Wasserstoffrest bedeuten können oder einen gegebenenfalls substituierten Kohlenwasserstoffrest oder eine Gruppe der Formel OR¹⁴ wobei R¹⁴ einen Kohlenwasserstoffrest bedeutet. Dabei können benachbarte Reste wie beispielsweise R¹⁰ und R¹² oder R¹¹ und R¹³ in Formel (IIIa) miteinander zu cyclischen Resten gekoppelt vorliegen, so dass annelierte Ringsysteme entstehen.

Typische Beispiele solcher verbrückender aromatischer Reste sind der p-, m- oder o-Phenylenrest, der 2-Methyl-1,4-Phenylenrest, der 2-methoxy-1,4-Phenylenrest, wobei der p-Phenylenrest besonders bevorzugt ist.

Gegebenenfalls können auch mehrere solcher Reste miteinander gekoppelt sein, so dass beispielsweise zwei oder mehr Einheiten der Formel (IIIa) miteinander gekoppelt vorliegen und dieses oligomere verbrückende Strukturelement durch Anbindung der entsprechenden Kohlenstoffatome der terminalen aromatischen Ringe an Siliziumatome vorliegt. Die aromatischen Einheiten können dabei direkt aneinander gebunden vorliegen oder sie können durch eine verbrückende Gruppe wie eine Alkandiyleinheit, wie beispielsweise der Methylengruppe, der 1,2-Ethandiylgruppe, 1,1-Ethandiylgruppe, der 2,2-Dimethylpropylgruppe oder einer Sulfongruppe miteinander gekoppelt sein.

Weitere Beispiele für aromatische verbrückende Einheiten sind solche, bei denen zwei gegebenenfalls substituierte Phenolringe, über eine Alkandiyl- oder andere Einheit verbrückt sind. Typische Vertreter sind am Phenolsauerstoff substituierte 2,2-Bis(4-hydroxyphenyl)propanreste (substituierte Bisphenol A Reste), 2,2-Bis(4-hydroxyphenyl)methanreste (subsituierte Bisphenol F Reste), Bis(4-hydroxyphenyl)sulfonreste (Bisphenol S Reste) wobei die Phenolsauerstoffatome typischerweise mit Resten der Art -(C₃H₆)- substituiert sind, wobei die Reste -(C₃H₆)- an Siliziumatome Si-C gebunden sind, wodurch die Verbrückung entsteht.

Bevorzugte nicht durch eine aromatische Einheit verbrückte Reste Y sind Alkandiyl-, Alkendiyl- und Alkindiylreste, die gegebenenfalls Heteroatome enthalten können und die aromatische Gruppen als Substituenten enthalten können, die in diesen Resten jedoch nicht die Aufgabe der Verbrückung übernehmen oder dazu beitragen.

Typische Beispiele sind der Methylenrest, der Methinrest, der vierwertige Kohlenstoff, die 1,1-Ethandiyl- und die 1,2-Ethandiylgruppe, die 1,4 Butandiyl- und die 1,3- Butandiylgruppe, die 1,5 Pentandiyl-, 1,6-Hexandiyl, 1,7-Heptandiyl-, 1,8-Octandiyl-, 1,9-Nonadiyl-, 1,10-Decandiyl- 1,11-Undecandiyl- und die 1,12-Dodecandiylgruppe, die 1,2-Diphenylethandiylgruppe, die 1,2-Phenylethandiyolgruppe, die 1,2-Cyclohexylethandiylgruppe. Sofern eine lineare verbrückende Einheit mehr als ein Kohlenstoffatom besitzt und es das Substitutionsmuster zulässt, kann jede dieser Gruppen außer durch die alpha-omega Konnektivität, also die Verbrückung durch das jeweils erste und letzte Atom einer linearen Einheit auch durch jede andere Konnektivität, also die Verwendung anderer Ketten-C-Atome verbrückend wirken. Zudem sind typische Beispiele nicht nur die linearen Vertreter der genannten verbrückenden Kohlenwasserstoffe, sondern auch deren Isomere, die wiederum durch Anbindung unterschiedlicher C-Atome der Kohlenwasserstoffstruktur an Siliziumatome verbrückend wirken können.

Beispiele für insbesondere bevorzugte Reste aus der Gruppe der nicht aromatischen heteroatomfreien Kohlenwasserstoffreste sind -CH₂CH₂-, -CH(CH₃)-, -CH=CH-, -C(=CH₂)- und -C≡C-.

Beispiele für typische fluorsubstituierte verbrückende Reste Y sind der -C(CF₃)₂-, der -C(H)F-C(H)F- und der -C(F₂)-C(F₂)-Rest.

Beispiele für typische heteroatomhaltige verbrückende Reste sind beispielsweise der Ethylenoxypropylenrest und der Ethylenoxybutylenrest. Auch beidseitig -(CH₂)ₙ- oder -CH₂-CH(R¹⁵)-C(=O)O-terminierte, wobei n typischerweise 3 bis 8 ist und R¹⁵ ein Wasserstoffatom oder eine Methylgruppe bedeutet und über diese terminale Gruppe an die Siliziumatome gebundene Glykolreste oder Phenylenetherreste sind typische Beispiele.

Alle Aufzählung sind nur beispielhaft und nicht einschränkend zu verstehen.

Die Organopolysiloxanverbindungen der Formel (I) können in Abhängigkeit der durchschnittlichen Anzahl der sie bildenden Struktureinheiten pro Molekül in ihrer Viskosität über einen weiten Bereich variieren oder auch Feststoffe sein.

Flüssige Organopolysiloxanverbindungen der Formel (I) besitzen im unvernetzten Zustand bei 25°C Viskositäten von bevorzugt 20 bis 8 000 000 mPas, besonders bevorzugt von 20 bis 5 000 000 mPas, insbesondere von 20 bis 3 000 000 mPas.

Feste Organopolysiloxanverbindungen der Formel (I)besitzen im unvernetzten Zustand Glasübergangstemperaturen im Bereich von bevorzugt 25°C bis 250°C, besonders bevorzugt von 30°C bis 230°C, insbesondere von 30°C bis 200°C. Als besonders geeignet haben sich solche Organopolysiloxane erwiesen, die verbrückende Phenyleneinheiten besitzen und die insgesamt einen aromatischen Anteil von mindestens 20 mol-% bezogen auf alle Si-C-gebundenen Substituenten als 100 mol-% besitzen. Unter Phenyleneinheiten werden dabei sowohl monomere als auch oligomere und substituierte sowie unsubstituierte Phenyleneinheiten verstanden, wie sie in den Beispielen für die Art der verbrückenden Substituenten dieses Typs illustrierend beschrieben sind.

Die Organopolysiloxanverbindungen der Formel (I) können nach beliebigen Verfahren hergestellt werden. Ein bevorzugtes Verfahren zur Herstellung dieser Verbindungen ist die Hydrolyse und Cokondensation von Verbindungen der allg. Formel (IV)

X₃-aRaSi-Y(SiRₐX₃₋ₐ)_{b} (IV)

mit Verbindungen der Formel (V)
R¹⁶ₕSiX₄₋ₕ (V),
wobei X eine hydrolysierbare Gruppe,
h eine ganze Zahl im Wert von 0 bis 3 bedeutet,
wobei R¹⁶ für h = 1 einen Rest R¹, für h = 2 einen Rest R² und für h = 3 einen Rest R³ bedeutet
und R, Y, a und b die bereits genannte Bedeutung haben.

Die Verbindungen (IV) werden nach Verfahren gemäß Stand der Technik erhalten, wobei die anzuwendenden Reaktionstypen stark von der Zusammensetzung der jeweiligen Verbindung (IV) abhängt. Typischerweise werden Verbindungen (IV) beispielsweise aus olefinisch ungesättigten organischen Vorstufen, wie beispielsweise Acetylen, Diallyl- oder Divinylverbindungen und Si-H-funktionellen Siliconbausteinen durch Hydrosilylierung erhalten.

Auch Grignardreaktionen aus halogenierten organischen Vorstufen und anschließende Umsetzung mit halogenierten oder alkoxylierten Organosilanen sind hier denkbare Verfahren. Gegebenenfalls können auch Metallhalogenidaustauschreaktionen halogenierter organischer Vorstufen mit Alkylalkalimetallverbindungen, wie etwa Butyllithium und bekannte Folgereaktionen zur Verknüpfung mit Siliconbausteinen Anwendung finden. Dem Fachmann sind solche Verfahren bekannt und aus der verfügbaren Literatur leicht zugänglich und nachvollziehbar. Da diese Verfahren nicht erfindungsgegenständlich sind, sei dazu an dieser Stelle lediglich der Verweis auf den dokumentierten und recherchierbaren Stand der Technik gegeben.

Die relativen Verhältnisse, in denen die Verbindungen der Formel (IV) mit den Verbindungen der Formel (V) cokondensiert werden, sind durch die Werte der Indices c, d, e, f und g in Formel (I) vorgegeben.

Bevorzugt ist X eine Halogen-, Säure- oder Alkoxygruppe, besonders bevorzugt eine Chlor-, Acetat-, Formiat-, Methoxy- oder Ethoxygruppe.

Die so erhaltenen Organosiloxane können gegebenenfalls durch weitere Reaktionen, wie beispielsweise die Equilibrierung weiter verändert und abgewandelt werden, so dass sich durch Anwendung bekannter Verfahren gemäß Stand der Technik nahezu beliebige verzweigte Siloxanoligomere und -polymere und Siliconharze herstellen lassen, die im Rahmen der vorliegenden Erfindung alle unter dem Begriff der Organopolysiloxane verstanden werden.

Vorzugsweise wird die Cohydrolyse so ausgeführt, dass ein Gemisch aus den Verbindungen (IV) und (V) unter Kühlung in Wasser oder verdünnte Säuren dosiert wird. Bei gasförmigen Säuren wie HCl ist eine Dosierung in eine konzentrierte wässrige HCl-Lösung ebenfalls sinnvoll, wenn die frei werdende Säure als Gas zurück gewonnen werden soll. Je nach der Natur der Gruppe X ist die Hydrolyse mehr oder weniger stark exotherm, so dass sowohl im Interesse der sicheren Ausführung der Reaktionen als auch gegebenenfalls zur Vermeidung von Nebenreaktionen in entsprechenden Sequenzen der Synthesen Kühlung erforderlich ist. Zur Vervollständigung der Reaktionen kann es hingegen vorteilhaft und erforderlich sein, erhöhte Temperaturen anzuwenden.

Die Reaktionszeiten sind im Fall von Chlorsilanen in der Regel sehr kurz, so dass die zur Durchführung des Verfahrens im Batchbetrieb benötigte Zeit hauptsächlich von der Kühlleistung abhängt. Alternativ kann die Cohydrolyse von (IV) und (V) auch kontinuierlich durchgeführt werden, wofür sich sowohl Loop, als auch Kolonnenreaktoren sowie Rohrreaktoren anbieten.

Zur Abreicherung von Restsäuren ist gutes Waschen mit Wasser, saubere Phasentrennung sowie Reinigung des Hydrolyseprodukts im Vakuum vorteilhaft.

Das Verfahren kann bei Normaldruck durchgeführt werden. Je nach Zielsetzung ist aber höherer oder niedriger Druck ebenfalls praktikabel.

Durch die Verwendung der Gruppen der Formel (R³₃SiO_{1/2})_{f} gelingt während der Synthese sowohl die Steuerung des Molekulargewichtes als auch die Reduzierung der Alkoxy und Silanolgruppen.

Letztere bilden sich während der Synthese, sofern diese in einem hydrolytischen Prozess durchgeführt wird, was die bevorzugte Ausführungsform ist. Wird zur Erzeugung der Gruppen der Formel (R³₃SiO_{1/2})_{f} eine Chlorsilanvorstufe eingesetzt, so bilden sich im Laufe der Synthese auch symmetrische Disiloxane aus denselben, die unter den Bedingungen der sauren Hydrolyse allerdings wieder spaltbar sind und daher als terminierende Gruppen weiterhin für Reaktionen mit Silanolgruppen zur Verfügung stehen, die am sich bildenden Organopolysiloxan nach Hydrolyse der Chlorsilan Ausgangsmaterialien entstehen. So gelingt die Reduzierung der Silanolgruppen. Da Alkoxygruppen, insbesondere solche mit kleinen Alkylresten unter den Bedingungen der sauren Hydrolyse unter Abspaltung kurzkettiger Alkohole ebenfalls Silanolgruppen bilden, werden auch die Alkoxygruppen durch die Mitverwendung der terminierenden Baugruppen reduziert. Man kann diese dabei auch im Überschuss einsetzen, da evtl. verbleibende Disiloxane nach beendeter Synthese in der Regel abdestilliert werden können, vor allem, wenn sie ausschließlich oder überwiegend mit kurzkettigen Alkylresten, vor allem Methylresten substituiert sind.

Man kann die diese terminalen Gruppen bildenden Chlorsilane oder Disiloxane auch in einem finalen Schritt der Synthese separat zusetzen und durch saure hydrolytische Bedingungen gezielt die Reduzierung der Silanolgruppen herbeiführen. Dabei ist es vorteilhaft stets einen Überschuss an terminierenden Chlorsilanen einzusetzen und die entstehenden Disiloxane destillativ zu entfernen. Besonders vorteilhaft können hierfür Vinyldimethylchlorsilan, Dimethylchlorsilan oder Trimethylchlorsilan eingesetzt werden, da die sich daraus bildenden Disiloxane besonders leicht destillativ abtrennbar sind. Alternativ ist es auch möglich gleich die Disiloxane einzusetzen und hydrolytische Bedingungen zu wählen, wobei in diesem Fall die Zugabe einer ausreichenden Menge katalystische wirkender Säure, vorzugsweise Salzsäure erforderlich ist. Typischerweise verwendet man in diesem Fall zwischen 50 und 1000 ppm Salzsäure bezogen auf die Menge an Siloxan in der Reaktionsmischung.

Man erreicht Rest Silanolgehalte von weniger als 1 Gewichtsprozent. Da die erschöpfende Eliminierung der Silanolgehalte auf das technisch mögliche Minimum nicht erfindungsgegenständlich ist, wurde dieser Schritt nicht weiter optimiert.

Die metallplattierten Schichtstoffe enthalten vorzugsweise Zubereitungen, die Organopolysiloxanverbindungen der Formel (I) und weitere Bestandteile enthalten.

Die Organopolysiloxanverbindungen der Formel (I) sind chemisch härtbar, d.h. sie können durch eine chemische Reaktion zu einem vernetzten unlöslichen Netzwerk ausgehärtet werden. Die Härtung erfolgt über die olefinisch ungesättigten Gruppen, die weiter oben beschrieben sind. Typischerweise kommt dabei entweder eine radikalische Polymerisatonsreaktion zur Härtung zum Einsatz oder falls neben den olefinisch oder acetylenisch ungesättigten funktionellen Gruppen auch siliziumgebundener Wasserstoff als Rest vorliegt, eine Hydrosilylierungshärtung.

Die Organopolysiloxanverbindungen der Formel (I) besitzen alle aliphatisch ungesättigte funktionelle Gruppen, über welche sie chemisch vernetzbar sind. Mögliche chemische Vernetzungsreaktionen umfassen dabei die bekannten Reaktionen gemäß Stand der Technik, insbesondere die radikalische Vernetzung, die sowohl unter Verwendung geeigneter Strahlenquellen wie UV-Licht als auch durch instabile zu Radikalen zerfallende chemische Verbindungen initiiert werden kann und die Additionsvernetzung beispielsweise durch eine Hydrosilylierung der olefinisch ungesättigten Gruppe mit einer Si-H Funktion in Gegenwart eines geeigneten Hydrosilylierungskatalysators, der ein weiterer Bestandteile der Zubereitungen ist.

Um eine ausreichende Härtung zu erreichen, muss eine ausreichende Menge funktioneller Gruppen vorhanden sein. Mindestens müssen je Molekül Organopolysiloxanverbindungen der Formel (I) durchschnittlich 1,0 funktionelle Gruppen vorhanden sein, um eine ausreichende Härtung zu erreichen, bevorzugt sind durchschnittlich mindestens 1,1 insbesondere durchschnittlich mindestens 1,2 funktionelle Gruppen je Molekül Organopolysiloxanverbindungen der Formel (I) vorhanden. Dabei können die funktionellen Gruppen verschieden sein, so dass beispielsweise ein Teil der funktionellen Gruppen eine Si-H-Gruppe ist und ein anderer Teil der funktionellen Gruppen eine olefinisch ungesättigte Gruppe darstellt, die radikalisch härtbar oder hydrosilylierbar ist. Auch weitere Kombinationen komplementärer funktioneller Gruppen sind denkbar, wobei komplementär bedeutet, dass die gewählten Kombinationen funktioneller Gruppen miteinander reagieren können. Falls nur eine Art funktioneller Gruppen vorhanden ist, beispielsweise nur olefinisch oder acetylenisch ungesättigte funktionelle Gruppen, die radikalisch härtbar sind, so muss die entsprechende Anzahl dieser funktionellen Gruppen gegeben sein. Im Sinne einer Copolymerisation zu einer homogenen Matrix ist dabei zu beachten, dass eine ausreichende Copolymerisierbarkeit der gewählten olefinischen und acetylenischen Gruppen gegeben ist. Auch die Kombination nicht miteinander copolymerisierbarer olefinischer Gruppen ist möglich, sofern die erzielte Matrix aus zwei oder gegebenenfalls mehr individuellen Polymeren miteinander verträglich bleibt und keine separaten Phasen bildet, die sich in unterscheidbaren Domänen voneinander trennen.

Als weiterer Bestandteile der Zubereitungen kann deshalb ein geeigneter Initiator anwesend sein, um die radikalische Polymerisation zu starten. Beispiele für geeignete Initiatoren, seien hier insbesondere Beispiele aus dem Feld der organische Peroxide genannt, wie Di-tert.-butylperoxid, Dilaurylperoxid, Dibenzoylperoxid, Dicumylperoxid, Cumylperoxyneodecanoat, tert-Butylperoxyneodecanoat, tert-Amylperoxypivalat, tert-Butylperoxypivalat, tert-Butylperoxyisobutyrat, tert-Butylper-oxy-3,5,5-trimethylhexanoat, tert-Butylcumylperoxid, tert-Butylperoxyacetat, tert-Butylperoxybenzoat, 1,1-Ditert.-butyl-peroxycyclohexan, 2,2-Di(tert.-butylperoxy)butan, Bis(4-tert.-butylcyclohexyl)peroxydicarbonat, Hexadecylperoxydicarbonat, Tetradecylperoxydicarbonat, Dibenzylperoxidicarbonat, Diisopropylbenzol Dihydroperoxid, [1,3-Phenylenbis(1-methylethyliden)]bis[tert-butyl]peroxid, 2,5-Dimethyl-2,5-di-(tert-butylperoxy)hexan, Dicetylperoxydicarbonat, Acetylacetonperoxid, Acetylcyclohexansulfonylperoxid, tert.-Amylhydroperoxid, tert-Amylperoxy-2-ethylhexanoat, tert-Amylperoxy-2-ethylhexylcarbonat, tert-Amylperoxyisopropylcarbonat, tert-Amylperoxyneodecanat, tert-Amylperoxy-3,5,5-trimethylhexanoat, tert-Butylmonoperoxymaleat, wobei diese Aufzählung nur illustrierend ist und nicht beschränkend. Gegebenenfalls können auch Mischungen aus verschiedenen Initiatoren für radikalische Reaktionen verwendet werden. Die Eignung eines Initiators bzw. Initiatorgemisches für radikalische Reaktionen hängt von dessen Zerfallskinetik und den zu erfüllenden Anforderungsbedingungen ab. Unter ausreichender Beachtung dieser Rahmenbedingungen gelingt dem Fachmann die geeignete Auswahl eines Initiators.

Bei Organopolysiloxanverbindungen der Formel (I) , die neben olefinisch und acetylenisch ungesättigten Gruppen auch siliziumgebundenen Wasserstoff enthalten, besteht die Möglichkeit der Härtung durch eine Hydrosilylierungsreaktion. Geeignete Katalysatoren zur Förderung der Hydrosilylierungsreaktion können als weiterer Bestandteile der Zubereitungen anwesend sein.

Beispiele für solche Katalysatoren sind Verbindungen oder Komplexe der Gruppe der Edelmetalle, enthaltend Platin, Ruthenium, Iridium, Rhodium und Palladium, vorzugsweise Metallkatalysatoren aus der Gruppe der Platinmetalle oder Verbindungen und Komplexe aus der Gruppe der Platinmetalle. Beispiele für solche Katalysatoren sind metallisches und feinverteiltes Platin, das sich auf Trägern wie Siliziumdioxid, Aluminiumoxid oder Aktivkohle befinden kann, Verbindungen oder Komplexe von Platin wie Platinhalogenide, z.B. PtCl₄, H₂PtCl₆x6H₂O, Na₂PtCl₄x4H₂O, Platin-Olefin-Komplexe, Platin-Alkohol-Komplexe, Platin-Alkoholat-Komplexe, Platin-Ether-Komplexe, Platin-Aldehyd-Komplexe, Platin-Keton-Komplexe, einschließlich Umsetzungsprodukten aus H₂PtCl₄x6H₂O und Cyclohexanon, Platin-Vinyl-Siloxankomplexe, wie Platin-1,3-Divinyl-1,1,3,3-tetramethyldisiloxan, mit oder ohne Gehalt an nachweisbarem anorganisch gebundenem Halogen, Bis-(gamma-picolin)-platinchlorid, Trimethylendipyridinplatinchlorid, Dicyclopentadienplatindichlorid, Dimethylsulfoxyethenylplatin(II)dichlorid, Cyclooctadienplatindichlorid, Norbornadienplatindichlorid, Gammapicolinplatindichlorid, Cyclopentadienplatindichlorid, sowie Umsetzungsprodukte von Platintetrachlorid mit Olefin und primärem oder sekundärem Amin oder primärem und sekundärem Amin wie das Umsetzungsprodukt aus in 1-Octen gelöstem Platintetrachlorid mit sec-Butylamin oder Ammoniumplatinkomplexe. In einer weiteren Ausführungsform werden Komplexe des Iridiums mit Cyclooctadiene, wie beispielsweise µ-Dichloro-bis(cyclooctadiene)-diiridium(I), verwendet.

Diese Aufzählung ist nur illustrierend und nicht beschränkend. Die Entwicklung der Hydrosilylierungskatalysatoren ist ein dynamisches Forschungsgebiet, das immer wieder neue wirksame Spezies hervorbringt, die naturgemäß ebenfalls hier eingesetzt werden können.

Vorzugsweise handelt es sich bei dem Hydrosilylierungskatalysator um Verbindungen oder Komplexe des Platins, bevorzugt um Platinchloride und Platinkomplexe, insbesondere um Platin-Olefin-Komplexe und besonders bevorzugt um Platin-Divinyltetramethyldisiloxankomplexe.

Bei dem Härtungsverfahren wird der Hydrosilylierungskatalysator in Mengen von 2 bis 250 Gewichts-ppm eingesetzt, vorzugsweise in Mengen von 3 bis 150 ppm, insbesondere in Mengen von 3 bis 50 ppm.

Die Organopolysiloxanverbindungen der Formel (I) eignen sich besonders gut zum Einsatz als Bindemittel zur Herstellung von metallkaschierten Elektrolaminaten, beispielsweise wie man sie zur Herstellung als Leiterplatten in elektronischen Geräten verwendet, insbesondere für Hochfrequenzanwendungen.

Besagte metallkaschierte Elektrolaminate können Verstärkungsmaterialien enthalten, müssen aber nicht. Das heißt sie können beispielsweise verstärkende Gewebe wie Fasergewebe oder Vliese enthalten oder sie können frei von solchen sein. Falls ein Verstärkungsmaterialien enthalten ist, ist dies vorzugsweise in Schichten angeordnet. Eine verstärkende Schicht kann dabei aus einer Vielzahl verschiedener Fasern aufgebaut sein. Solche verstärkenden Schichten helfen das Schrumpfverhalten zu kontrollieren und geben erhöhte mechanische Festigkeit.

Sofern eine verstärkende Schicht mitverwendet wird, können die diese Schicht bildenden Fasern ausgewählt werden aus einer Vielzahl verschiedener Möglichkeiten. Nicht beschränkende Beispiele für solche Fasern sind Glasfasern, wie beispielsweise E-Glasfasern, S-Glasfasern und D-Glasfasern, Silicafasern, Polymerfasern, wie beispielsweise Polyetherimidfasern, Polysulfonfasern, Polyetherketonfasern, Polyesterfasern, Polycarbonatfasern, aromatische Polyamidfasern oder flüssigkristalline Fasern. Die Fasern können einen Durchmesser von 10 nm bis 10 µm aufweisen. Die Verstärkungsschicht hat eine Stärke von höchstens 200 µm, vorzugsweise höchstens 150 µm.

Eine bevorzugte Anwendungsform ist die Verwendung der Organopolysiloxanverbindungen der Formel (I) als Bindemittel oder Cobindemittel zusammen mit organischen Bindemitteln zur Herstellung von metallkaschierten Laminaten aus Glasfasercompositen zur weiteren Herstellung von Leiterplatten. Das bevorzugte Metall ist Kupfer.

Die Organopolysiloxanverbindungen der Formel (I) können als alleiniges Bindemittel verwendet werden. Als weiterer Bestandteile der Zubereitungen können auch organische Bindemittel anwesend sein. Organische Bindemittel sind z.B. organischen Monomeren, Oligomeren und Polymeren verwendet werden. Typischerweise hierfür verwendete organische Monomere, Oligomere und Polymere umfassen Polyphenylenether, Bismaleimide, Bismaleimid Triazin Copolymere, Kohlenwasserstoffharze, sowohl aliphatische wie beispielsweise Polybutadien, als auch aromatische wie beispielsweise Polystyrol, als auch Hybridsysteme, die sowohl aliphatischen als auch aromatischen Charakter haben wie beispielsweise Styrolpolyolefin Copolymere, wobei die Form der Copolymeren grundsätzlich wiederum nicht eingeschränkt ist, Epoxidharze, Cyanatesterharze und gegebenenfalls andere, wobei die Auswahl illustrierend zu verstehen ist und nicht einschränkend.

Bevorzugte organische Monomere, Oligomere und Polymere sind oligomere und polymere Polyphenylenether, monomere, oligomere und polymere Bismaleimide, oligomere und polymere Kohlenwasserstoffharze sowie Bismaleimid Triazin Copolymere. Dabei können die organischen Monomere, Oligomere und Polymere gegebenenfalls miteinander gemischt eingesetzt werden.

Der Anteil der organischen Monomere, Oligomere und Polymere in den Zubereitungen mit den Organopolysiloxanverbindungen der Formel (I), sofern die organischen Komponenten mitverwendet werden, beträgt zwischen 10 und 90% bezogen auf die Mischung aus den Organopolysiloxanverbindungen der Formel (I) und den organischen Monomeren, Oligomeren und Polymeren als 100%, bevorzugt 20 - 90%, insbesondere 30 - 80%.

Darüber hinaus können sowohl die Organopolysiloxanverbindungen der Formel (I) als auch die Mischungen derselben mit organischen Monomeren, Oligomeren oder Polymeren in weiteren organischen Monomeren gegebenenfalls mit olefinisch oder acetylenisch ungesättigten Gruppen als Reaktivverdünner gelöst werden, wie beispielsweise Styrol, alpha Methylstyrol, para-Methylstyrol und Vinylstyrol, Chlor- und Bromstyrol.

Ebenso können die Zubereitungen als weitere Bestandteile typische nicht reaktive Lösemittel zur Lösung der Organopolysiloxanverbindungen der Formel (I) und gegebenenfalls Gemische derselben mit organischen Monomeren, Oligomeren und Polymeren enthalten, wie beispielsweise aliphatische oder aromatische Lösemittel wie aliphatische Gemische mit bestimmten Siedebereichen, Toluol, Xylol, Ethylbenzol oder Gemische derselben Aromaten, Ketone, wie Aceton, Methylethylketon, Cyclohexanon, Carbonsäureester, wie Ethylacetat, Methylacetat, Ethylformiat, Methylformiat, Propionsäuremethylester, Propionsäureethylester, wobei eine gute Löslichkeit insbesondere der Gemische aus Organopolysiloxanverbindungen der Formel (I) mit organischen Monomeren, Oligomeren und Polymeren am ehesten in aromatischen Lösemitteln wie Toluol, Xylol, Ethylbenzol und Gemischen derselben erreicht wird.

In dem Falle, dass die Organopolysiloxanverbindungen der Formel (I) in Kombination mit einem organischen Oligomer oder Polymer oder Gemischen derselben eingesetzt werden, ist es wesentlich, dass Organopolysiloxanverbindungen der Formel (I) verwendet werden, die mit den organischen Komponenten der Wahl verträglich sind und nicht zu Phasenseparationen führen. In diesen Fällen sind in der Regel phenylreichere Organopolysiloxanverbindungen der Formel (I) einzusetzen, da Phenylgruppen die Verträglichkeit mit den organischen Komponenten erhöhen. Insbesondere mit aromatenreicheren organischen Polymeren wie Polyphenylenethern oder aromatischen Kohlenwasserstoffharzen sind aromatenreichere Organopolysiloxanverbindungen der Formel (I) zu verwenden, wobei zur Verträglichkeitseinstellung sowohl die verbrückenden aromatischen Gruppen als auch terminal an Silyleinheiten gebundene aromatische Substituenten beitragen.

Die genaue Menge der aromatischen Gruppen, die notwendig ist, um die Verträglichkeit der Organopolysiloxanverbindungen der Formel (I) mit einer bestimmten Auswahl an organischen Bindemitteln einzustellen muss in Abhängigkeit der Auswahl an organischen Bindemitteln ermittelt werden.

Ebenso wie es möglich ist, mehrere organische Polymere zu mischen, die sich gegebenenfalls aus verschiedenen Polymerklassen ausgewählt werden und in der Bindemittelzubereitung zu verwenden. Es ist auch möglich mehrere Organopolysiloxanverbindungen der Formel (I) miteinander in Bindemittelzubereitung zu kombinieren. D.h. es ist erfindungsgemäß sowohl nur eine einzige Organopolysiloxanverbindung der Formel (I) als Bindemittel zu verwenden, als auch mehrere Organopolysiloxanverbindungen der Formel (I) miteinander zu einer Bindemittelzubereitung zu kombinieren. Ebenso ist es erfindungsgemäß nur eine Organopolysiloxanverbindungen der Formel (I) mit einem oder mehreren organischen Polymeren zu einer Bindemittelzubereitung zu kombinieren. Es ist auch erfindungsgemäß mehrere Organopolysiloxanverbindungen der Formel (I) mit einem oder mehreren verschiedenen organischen Polymeren zu einer Bindemittelzubereitung zu kombinieren.

Die Feststellung der Verträglichkeit eines oder mehrerer Organopolysiloxanverbindungen der Formel (I) mit einem oder mehreren organischen Oligomeren oder Polymeren gelingt leicht, indem man eine Mischung des oder der organischen Bindemittel mit dem oder den Organopolysiloxanverbindungen der Formel (I) vorteilhafter Weise in einem Lösemittel, das alle ausgewählten Komponenten löst, mischt, anschließend das Lösemittel nach Methoden gemäß Stand der Technik, beispielsweise durch Destillation oder Sprühtrocknen entfernt und den erhaltenen Rückstand optisch oder unter Zuhilfenahme mikroskopischer gegebenenfalls elektronenmikroskopischer Methoden bewertet. Verträgliche Mischungen erkennt man daran, dass sich keine Silicondomänen von den organischen Bestandteilen abtrennen und als eigene Phase erkennbar sind.

Die Zubereitungen können als weitere Bestandteile weitere Formulierungskomponenten, wie Additive, die gegebenenfalls auch Silane umfassen können, wie beispielsweise Antischaum- und Entlüftungsmitteln, Netz- und Dispergiermittel, Verlaufsmittel, Kompatibilisatoren, Haftvermittler, Härtungsinitiatoren, Katalysatoren, Stabilisatoren, Füllstoffe einschließlich Pigmenten, Farbstoffen, Inhibitoren, flammhemmende Additive, Vernetzungshilfsmittel enthalten. Außer Prüfungen der Verträglichkeit im Sinne eines geeigneten Mischbarkeitsverhaltens sind gegebenenfalls auch Prüfungen der Verträglichkeit hinsichtlich der Reaktivität erforderlich, um sowohl ein vorzeitiges Gelieren zu verhindern als auch sicherzustellen, dass während der Härtung eine ausreichend schnelle Polymerisation bzw. Copolymerisation aller Komponenten miteinander erreicht wird, ebenso wie Prüfungen auf ausreichende Benetzung und gegebenenfalls weiterer Eigenschaften. Dies ist im Rahmen der Formulierungserstellung gegebenenfalls zu beachten und zu berücksichtigen.

Beispiele für verwendbare Füllstoffe sind keramische Füllstoffe wie etwa Kieselsäuren, beispielsweise Fällungskieselsäuren oder pyrogene Kieselsäuren, die sowohl hydrophil als auch hydrophob sein können und vorzugsweise hydrophob sind und die des Weiteren auch mit organischen Gruppen auf ihrer Oberfläche funktionell und gegebenenfalls reaktiv ausgestattet sein können, Quarz, der gegebenenfalls oberflächenbehandelt oder oberflächenfunktionalisiert sein kann, so dass er gegebenenfalls reaktive funktionelle Gruppen auf der Oberfläche tragen kann, Aluminiumoxide, Aluminiumhydroxide, Calciumcarbonat, Talk, Glimmer, Ton, Kaolin, Magnesiumsulfat, Ruß, Titandioxid, Zinkoxide, Antimontrioxid, Bariumtitanat, Strontiumtitanat, Korund, Wollastonit, Zirkoniumwolframat, keramische Hohlkugeln, Aluminiumnitrid, Siliziumcarbid, Berylliumoxid, Magnesiumoxid, Magnesiumhydroxid, volle Glaskugeln, hohle Glaskugeln und Bornitrid. Als weitere Füllstoffe können Kern-Hülle-Partikel aus verschiedenen Materialien eingesetzt werden, die etwa oberflächlich kieselsäurebelegte Siliconharzkugeln, polymerbelegte Elastomerpartikel, wobei die Elastomerpartikel gegebenenfalls auch Siliconelastomere sein können und ein typisches Beispiel für eine Oberflächenbelegung eines solchen Elastomerpartikels eine Polymethylmethacrylathülle ist. Die keramischen Füllstoffe haben vorzugsweise Partikelgrößen ausgedrückt als D₉₀ Wert von 0,1 µm bis 10 µm. Füllstoffe sind vorzugsweise vorhanden in Mengen von 0,1 bis 60 Gewichtsprozent, bevorzugt von 0,5 bis 60 Gewichtsprozent, insbesondere von 1 bis 60 Gewichtsprozent bezogen auf die gesamte Bindemittelformulierung bestehend aus Bindemittel bzw. Bindemitteln, reaktiven Monomeren, Additiven, und Füllstoffen als 100%. D.h. die Menge eines evtl. eingesetzten nicht reaktiven Lösemittels wird nicht mitgezählt.

Bei den Füllstoffen sind solche besonders hervorzuheben, die thermisch leitfähig sind. Diese sind Aluminiumnitrid, Bornitrid, Siliziumcarbid, Diamant, Graphit, Berylliumoxid, Zinkoxid, Zirkoniumsilikat, Magnesiumoxid, Siliziumoxid und Aluminiumoxid.

Grundsätzlich können die Bindemittelzubereitungen flammhemmende Additive enthalten in einer Menge von üblicherweise 5 bis 25 Gewichtsprozent. Es ist allerdings eine Besonderheit der Organopolysiloxanverbindungen der Formel (I), dass sie den Bedarf an flammhemmenden Additiven reduzieren, da die Organopolysiloxanverbindungen der Formel (I) selbst bereits flammhemmende Eigenschaften zeigen. Polysilsesquioxane und Siloxane sind bekannt dafür flammhemmende Eigenschaften zu zeigen und es gehört zum Stand der Technik, dass sie selbst als flammhemmende Additive eingesetzt werden. Es ist daher ein besonderer Vorteil der vorliegenden Erfindung, dass es hier gelingt die Funktion des Bindemittels mit der Funktion der Flammhemmung zu verknüpfen. In Abhängigkeit von der eingesetzten Menge an Organopolysiloxanverbindungen der Formel (I) kann daher die Menge an flammhemmenden Additiven reduziert werden. Bei einer Menge von mindestens 20 Gewichtsprozent bezogen auf die gesamte Mischung aller verwendeten Bindemittel und reaktiven organischen Monomere beträgt die Menge an flammhemmenden Additiven vorzugsweise nur noch 0 bis 10 Gewichtsprozent, besonders bevorzugt 0 bis 8 Gewichtsprozent, insbesondere 0 bis 5 Gewichtsprozent, d.h. es ist möglich bei Einsatz der Organopolysiloxanverbindungen der Formel (I) je nach Auswahl des Organopolysiloxans und der eingesetzten Menge auf den Einsatz eines flammhemmenden Additives zu verzichten.

Typische Beispiele für flammhemmende Additive sind Hydrate der Metalle Al, Mg, Ca, Fe, Zn, Ba, Cu oder Ni und Borate des Ba und Zn. Die flammhemmenden Additive können oberflächenbehandelt sein, wobei sie gegebenenfalls reaktive Gruppen auf der Oberfläche besitzen können. Es kann sich bei den flammhemmenden Additiven auch um halogenierte organische flammhemmende Additive handeln, wie beispielsweise Hexachloroendomethylentetrahydrphthalsäure, Tetrabromphthalsäure oder Dibromneopentylglykol. Beispiele für weitere flammhemmende Additive sind Melamincyanurat, Phosphor haltige Komponenten, wie Phosphinate, Diphosphinate, Phopsphazene, Vinylphosphazene, Phosphonate, Phosphaphenantreneoxide, feinkörnige Melaminpolyphosphate.

Weitere Beispiele für bromhaltige flammhemmende Additive sind Bispentabromphenylethan, Ethylenbistetrabromphthalimid, Tetradecabromdiphenoxybenzol, Decabromdiphenyloxid oder bromierte Polysilsesquioxane. Einige flammhemmende Additive verstärken sich in ihrer Wirkung synergistisch. Das ist beispielsweise der Fall für die Kombination von halogenierten Flammschutzadditiven mit Antimontrioxid.

Die Zubereitungen können als weitere Bestandteile auch Antioxidationsmittel, Stabilisatoren gegen Abbau durch Bewitterung, Gleitmittel, Weichmacher, farbgebende Mittel, phosphoreszierende oder andere Mittel zum Zwecke der Markierung und Nachverfolgbarkeit und Antistatikmittel enthalten.

Als Vernetzungshilfsmittel kommen insbesondere mehrfach ungesättigte radikalisch härtbare oder hydrosilylierbare Monomere und Oligomere zur Anwendung wie sie in nachfolgenden nicht beschränkenden Beispielen illustriert sind. Dazu gehören beispielsweise zweifach olefinisch ungesättigte Komponenten wie beispielsweise symmetrisch olefinisch ungesättigt disubstituierte Disiloxane, wie 1,1,3,3-Tetramethyl-1,3-divinyldisiloxan, 1,1,3,3-Tetramethyl-1,3-dipropylmethacryloyldisiloxan, zweifach olefinisch ungesättigt disubstituierte beispielsweise diallyl-, divinyl-, diacryloyl- oder dmethacryloylsubstiuierte organische Monomere oder Oligomere wie beispielsweise konjugierte und nicht konjugierte Diene, wie 1,9-Decadien, 1,3-Butadien. Ebenso gehören hierzu dreifach olefinisch ungesättigte Monomere oder Oligomere wie 1,2,4-Trivinylcyclohexan, Triallylcyanurate oder Triallylisocyanurate, Tri(meth)acrylate, wie beispielsweise Trimethylolpropantrimethacrylat.

Ebenso gehören hierzu vierfach ungesättigt substituierte Monomere und Oligomere wie beispielsweise 2,4,6,8-Tetramethyl-2,4,6,8-tetravinylcyclotetrasiloxan, 2,4,6,8-Tetraphenyl-2,4,6,8-tetravinylcyclotetrasiloxane, 2,2-Bis[[(2-methyl-1-oxoallyl)oxy]methyl]-1,3-propandiylbismethacrylat (Pentaerythritoltetramethacrylat), Tetraallylorthosilikat, Tetra-allyl-cia,cis,cis,cis-1,2,3,4-cyclopentantetracarboxylat, Tetraallylsilane, Glyoxalbis(diallylacetal).

Da neben der radikalischen Härtung auch die Hydrosilylierungshärtung denkbar ist, können auch mehrfach Si-H-funktionelle Komponenten als Vernetzer wirken, wie beispielsweise 1,1,3,3-Tetramethyl-1,3-disiloxan, 2,4,6,8-Tetramethyl-cyclotetrasiloxan, 1,4-Bis(dimethylsilyl)benzol oder mehrfach ketten- und / oder endständig Si-H-funktionelle Oligo- und Polyorganosiloxane.

Als Katalysatoren bzw. Initiatoren kommen für die radikalische Härtung der Bindemittelzubereitungen aus Organopolysiloxanverbindungen der Formel (I) und organischen Monomeren, Oligomeren und Polymeren die gleichen in Frage wie sie bereits weiter oben genannt sind, also insbesondere Peroxide. Darüber hinaus sind zur Initiierung der radikalischen Härtung sowohl der Organopolysiloxanverbindungen der Formel (I) alleine als auch der beschriebenen Bindemittelzubereitungen weitere Radikalstarter geeignet wie beispielsweise Azokomponenten, wie beispielsweise α,α'Azobis(isobutyronitril), Redoxinitiatoren wie zum Beispiel Kombinationen aus Peroxiden wie Wasserstoffperoxid und Eisensalzen oder Azide wie Acetylazid.

Die Organopolysiloxanverbindungen der Formel (I) bzw. die Zubereitungen diese enthaltend, können für die erfindungsgemäße Anwendung sowohl lösemittelfrei als auch als lösemittelhaltige Zubereitung eingesetzt werden. In der Regel werden sie als lösemittelhaltige Zubereitung eingesetzt, um die homogene Verteilung aller Komponenten der Formulierung ineinander und die Benetzung und Durchtränkung einer evtl. verwendeten Verstärkungsschicht zu erleichtern. In der Regel wird eine Verstärkungsschicht mit eingesetzt. Bevorzugt handelt es sich dabei um ein Glasfasergewebe. Die Durchtränkung der Verstärkungsschicht kann durch imprägnierenden Auftrag der Zubereitung erfolgen, wobei hierfür verschiedene technische Lösungen zur Verfügung stehen, gegebenenfalls auch kontinuierliche Verfahren und deren Auswahl zur Herstellung der erfindungsgemäßen metallkaschierten Laminate in keiner Weise eingeschränkt ist. Nicht limitierende Beispiele für Auftragstechniken sind das Tauchen, gegebenenfalls von Bahnen des Verstärkungsmaterials über Rollensysteme in kontinuierlichen Prozessen, das Sprühen, Fluten, Rakeln, etc. Es ist ein Vorteil der vorliegenden Erfindung, dass alle zur Verfügung stehenden Technologien ohne Einschränkung und Modifizierung angewendet werden können und kein spezielles neues Verfahren für den Einsatz der Organopolysiloxanverbindungen der Formel (I) erforderlich ist. Insofern bewegt sich die vorliegende Erfindung in der Herstellung der metallkaschierten Laminate vollumfänglich im verfügbaren Stand der Technik. Neu ist die Verwendung der Organopolysiloxanverbindungen der Formel (I) für die Herstellung der betreffenden metallkaschierten Laminate, die bislang unbekannt ist.

Nach dem Imprägnieren folgt ein Trockenschritt, bei dem gegebenenfalls verwendetes Lösemittel entfernt wird. Auch für den Trocknungsprozess finden Methoden nach Stand der Technik Anwendung. Diese umfassen insbesondere das thermisch induzierte Verdampfen mit oder ohne Vakuum. Durch geeignete Einstellung der Reaktivität und der Klebrigkeit der verwendeten Bindemittelmischung werden nach diesem Schritt unter geeigneten Bedingungen, wie beispielsweise Kühlung, lagerfähige Composite Materialien erhaltenen, die gegebenenfalls zu einem späteren Zeitpunkt weiter verarbeitet werden können.

In einem letzten Schritt des Verfahrens erfolgt die Polymerisation der Bindemittelzubereitung wiederum nach Methoden gemäß Stand der Technik. Gegebenenfalls mitverwendete Initiatoren für die radikalische Polymerisation werden dabei über ihre Zersetzungstemperatur hinaus erhitzt, so dass sie unter Bildung von Radikalen zerfallen und die radikalische Polymerisation der Bindemittelzubereitung initiieren. Grundsätzlich sind auch Methoden der Strahlenhärtung anwendbar.

Wird statt der radikalischen Polymerisation die Hydrosilylierungshärtung verwendet, ist in diesem Schritt eine Temperatur anzuwenden, die geeignet ist, den zum verwendeten Hydrosilylierungskatalysator mit verwendeten Inhibitor zu deaktivieren und die katalytische Aktivität des Hydrosilylierungskatalysators freizusetzen.

Dieser Schritt erfolgt in der Regel bei erhöhter Temperatur von vorzugsweise 100 bis 390°C, besonders bevorzugt von 100 bis 250°C, insbesondere von 130 bis 200°C, wobei die Temperatur für eine Zeit von vorzugsweise 5 bis 180 min wirksam ist, besonders bevorzugt 5 bis 150 min, insbesondere 10 bis 120 min. Außerdem ist es üblich bei diesem Schritt erhöhten Druck anzuwenden. Übliche Drucke liegen im Bereich von 1 bis 10 MPa, besonders bevorzugt von 1 bis 5 MPa, insbesondere von 1 bis 3 MPa.

Die Laminierung des Composite Materials mit einer leitfähigen Metallschicht erfolgt in diesem zweiten Schritt, indem eine Schicht mindestens eines ausgewählten Metalls auf einer oder auf beiden Seiten des Composite Materials aus Verstärkungsschicht und Bindemittelzubereitung aufgebracht wird, bevor die Härtung stattfindet. D.h. zwischen dem ersten Schritt bestehend aus Imprägnierung und Trocknung und dem zweiten Schritt umfassend die chemische Härtung der Bindemittelzubereitung, erfolgt das Kaschieren des Composites aus dem ersten Schritt mit mindestens einer Sorte eines leitfähigen Metalls.

Als leitfähige Metalle kommen insbesondere mindestens eines aus folgender Auswahl in Frage: Kupfer, Edelstahl, Gold, Aluminium, Silber, Zink, Zinn, Blei und Übergangsmetalle. Die Dicke der leitfähigen Schicht, ihre Form, Größe oder Oberflächentextur sind nicht grundsätzlich eingeschränkt. Die leitfähige Metallschicht hat vorzugsweise eine Dicke von 3 bis 300 µm, besonders bevorzugt von 3 bis 250 µm, insbesondere von 3 bis 200 µm. Dabei kann die Dicke der beiden Schichten mindestens einer Sorte eines leitfähigen Metalls, sofern zwei Schichten verwendet werden, variieren und muss nicht identisch sein. Besonders bevorzugt ist es, dass das leitfähige Metall Kupfer ist und dass in dem Fall, dass zwei leitfähige Schichten aus leitfähigem Metall verwendet werden, beide Schichten Kupfer sind. Das leitfähige Metall wird vorzugsweise in Form einer Folie aus dem betreffenden Metall verwendet. Der Mittenrauwert Ra der eingesetzten Metallfolie beträgt vorzugsweise höchstens 2 µm, besonders bevorzugt höchstens 1 µm, insbesondere höchstens 0,7 µm. Je geringer die Oberflächenrauigkeit ist, desto besser ist die Eignung der jeweiligen Folie für den Einsatz in Hochfrequenzanwendungen, die das bevorzugte Ziel der vorliegenden Erfindung sind. Zur Verbesserung der Haftung zwischen der leitfähigen Metallschicht und dem Composite aus Bindemittelzubereitung und Verstärkungsschicht, können gegebenenfalls verschiedene Methoden gemäß Stand der Technik eingesetzt werden, wie beispielsweise die Verwendung einer haftvermittelnden Schicht, die galvanotechnische Abscheidung der Metallschicht auf dem Composite aus Bindemittelzubereitung und Verstärkungsschicht oder die Gasphasenabscheidung. Die Schicht aus leitfähigem Metall kann direkt auf dem Composite aus Bindemittelzubereitung und Verstärkungsschicht sitzen oder durch eine haftvermittelnde Schicht mit derselben verbunden sein.

Falls keine Verstärkungsschicht mitverwendet wird, erfolgt vorzugsweise die Erzeugung einer Schicht aus der Bindemittelzubereitung enthaltend die Organopolysiloxanverbindungen der Formel (I) durch Abscheidung einer Schicht aus Bindemittelzubereitung auf einem Träger, wie beispielsweise einer Trennfolie oder Trennplatte, wobei für den Träger grundsätzlich jedes Material geeignet ist, von dem die getrocknete oder gehärtete Bindemittelzubereitung später wieder ablösbar ist, wie beispielsweise Polytetrafluorethylen, Polyester und dergleichen. Die Ablösbarkeit sowie die Filmbildungseigenschaften auf dem jeweiligen Trägermaterial sind in Abhängigkeit von der Bindemittelzusammensetzung individuell zu bestimmen. Die getätigten Aussagen zum Verfahren bleiben für diese verstärkungsfreie Variante in gleicher Weise gültig.

Aus den verstärkten oder unverstärkten Composite Materialien aus dem ersten und den laminierten Composite Materialien aus dem zweiten Schritt lassen sich mehrschichtige Aufbauten erzeugen, indem mehrere Langen der Composite Materialien aus dem ersten Schritt beispielsweise abwechselnd mit den kaschierten Laminaten aus dem zweiten Schritt übereinander gestapelt werden und die noch nicht gehärteten Composite Materialien aus dem ersten Schritt anschließend in einem Prozess, der im Wesentlichen der Vorgehensweise zur Erzeugung der metallkaschierten Laminate entspricht gehärtet wird. Zur Erzeugung dickerer Schichten können hierbei auch mehrere Lagen aus den verstärkten oder unverstärkten Compositen aus dem ersten Schritt in unmittelbarer Reihenfolge übereinandergestapelt werden.

Die Organopolysiloxanverbindungen der Formel (I) können außer für die Herstellung metallkaschierter Laminate des Weiteren in korrosionsschützenden Zubereitungen verwendet werden, insbesondere zur Verwendung zum Zwecke des Korrosionsschutzes bei hoher Temperatur.

Außerdem können die Organopolysiloxanverbindungen der Formel (I) und Zubereitungen, die diese enthalten auch zum Korrosionsschutz von Armierungsstahl in Stahlbeton eingesetzt werden. korrosionsinhibierende Effekte im Stahlbeton werden dabei sowohl dann erreicht, wenn man die Organopolysiloxanverbindungen der Formel (I) und Zubereitungen, die diese enthalten in die Betonmischung einbringt, bevor sie in Form gebracht und ausgehärtet werden, als auch wenn man die Organopolysiloxanverbindungen der Formel (I) oder Zubereitungen, die diese enthalten auf die Oberfläche des Betons aufbringt, nachdem der Beton ausgehärtet ist.

Außer zum Zwecke des Korrosionsschutzes auf Metallen können die Organopolysiloxanverbindungen der Formel (I) auch zur Manipulation von weiteren Eigenschaften von Zubereitungen, die die Organopolysiloxanverbindungen der Formel (I) enthalten oder von Festkörpern oder Filmen, die aus Zubereitungen erhalten werden, die die Organopolysiloxanverbindungen der Formel (I) enthalten, dienen wie z.B.:
- Steuerung des elektrischen Leitfähigkeit und des elektrischen Widerstandes
- Steuerung der Verlaufseigenschaften einer Zubereitung
- Steuerung des Glanzes eines feuchten oder gehärteten Filmes oder eines Objektes
- Erhöhung der Bewitterungsbeständigkeit
- Erhöhung der Chemikalienresistenz
- Erhöhung der Farbtonstabilität
- Reduzierung der Kreidungsneigung
- Reduzierung oder Erhöhung der Haft- und Gleitreibung auf Festkörpern oder Filmen erhalten aus Zubereitungen, die Organopolysiloxanverbindungen der Formel (I) enthaltend
- Stabilisierung oder Destabilisierung von Schaum in der Zubereitung, die die erfindungsgemäße Zubereitung enthält
- Verbesserung der Haftung der Zubereitung die die Organopolysiloxanverbindungen der Formel (I) enthält zu Substraten
- Steuerung des Füllstoff- und Pigmentnetz- und -dispergierverhaltens,
- Steuerung der rheologischen Eigenschaften der Zubereitung, die die Organopolysiloxanverbindungen der Formel (I) enthält,
- Steuerung der mechanischen Eigenschaften, wie z.B. Flexibilität, Kratzfestigkeit, Elastizität, Dehnbarkeit, Biegefähigkeit, Reißverhalten, Rückprallverhalten, Härte, Dichte, Weiterreißfestigkeit, Druckverformungsrest, Verhalten bei verschiedenen Temperaturen, Ausdehnungskoeffizient, Abriebfestigkeit sowie weiterer Eigenschaften wie der Wärmeleitfähigkeit, Brennbarkeit, Gasdurchlässigkeit, Beständigkeit gegen Wasserdampf, Heißluft, Chemikalien, Bewitterung und Strahlung, der Sterilisierbarkeit, von Festkörpern oder Filmen erhältlich, die die Organopolysiloxanverbindungen der Formel (I) oder diese enthaltende Zubereitungen enthält
- Steuerung der elektrischen Eigenschaften, wie z.B. dielektrischer Verlustfaktor, Durchschlagfestigkeit, Dielektrizitätskonstante, Kriechstromfestigkeit, Lichtbogenbeständigkeit, Oberflächenwiderstand, spezifischer Durchschlagswiderstand,
- Steuerung der mechanischen Eigenschaften, wie z.B. Flexibilität, Kratzfestigkeit, Elastizität, Dehnbarkeit, Biegefähigkeit, Reißverhalten, Rückprallverhalten, Härte, Dichte, Weiterreißfestigkeit, Druckverformungsrest, Verhalten bei verschiedenen Temperaturen von Festkörpern oder Filmen erhältlich aus der Zubereitung die die Organopolysiloxanverbindungen der Formel (I) enthält.

Beispiele für Anwendungen, in denen die Organopolysiloxanverbindungen der Formel (I) eingesetzt werden kann, um die oben bezeichneten Eigenschaften zu manipulieren, sind die Herstellung von Beschichtungsstoffen und Imprägnierungen und daraus zu erhaltenden Beschichtungen und Überzügen auf Substraten, wie Metall, Glas, Holz, mineralisches Substrat, Kunst- und Naturfasern zur Herstellung von Textilien, Teppichen, Bodenbelägen, oder sonstigen aus Fasern herstellbaren Gütern, Leder, Kunststoffe wie Folien, und Formteilen. Die Organopolysiloxanverbindungen der Formel (I) können in Zubereitungen bei entsprechender Auswahl der Zubereitungskomponenten außerdem als Additiv zum Zwecke der Entschäumung, der Verlaufsförderung, Hydrophobierung, Hydrophilierung, Füllstoff- und Pigmentdispergierung, Füllstoff- und Pigmentbenetzung, Substratbenetzung, Förderung der Oberflächenglätte, Reduzierung des Haft- und Gleitwiderstandes auf der Oberfläche der aus der additivierten Zubereitung erhältlichen ausgehärteten Masse eingesetzt werden. Die Organopolysiloxanverbindungen der Formel (I) können in flüssiger oder in ausgehärteter fester Form in Elastomermassen eingearbeitet werden. Hierbei können sie zum Zwecke der Verstärkung oder zur Verbesserung anderer Gebrauchseigenschaften, wie der Steuerung der Transparenz, der Hitzebeständigkeit, der Vergilbungsneigung, oder der Bewitterungsbeständigkeit, eingesetzt werden.

Alle vorstehenden Symbole der vorstehenden Formeln weisen ihre Bedeutungen jeweils unabhängig voneinander auf. In allen Formeln ist das Siliziumatom vierwertig.

### Beispiele:

Die folgenden Beispiele dienen der weiteren Erläuterung der Erfindung. Sie sind illustrierend zu verstehen, nicht beschränkend.

Alle Prozentangaben beziehen sich auf das Gewicht. Falls nicht anders angegeben, werden alle Manipulationen bei Raumtemperatur von 23°C und unter Normaldruck (1,013 bar) ausgeführt. Falls nicht anders angegeben, gelten alle Daten zur Beschreibung von Produkteigenschaften bei Raumtemperatur von 23°C und unter Normaldruck (1,013 bar).

Bei den Apparaten handelt es sich um handelsübliche Laborgeräte, wie sie von zahlreichen Geräteherstellern käuflich angeboten werden.
Ph bedeutet einen Phenylrest = C₆H₅-
Me bedeutet einen Methylrest = CH₃-. Me₂ bedeutet entsprechend zwei Methylreste.
PPE bedeutet Polyphenylenether.
HCl bedeutet Chlorwasserstoff.

Im vorliegenden Text werden Stoffe durch Angabe von Daten charakterisiert, die mittels instrumenteller Analytik erhalten werden. Die zugrundeliegenden Messungen werden entweder öffentlich zugänglichen Normen folgend durchgeführt oder nach speziell entwickelten Verfahren ermittelt. Um die Klarheit der mitgeteilten Lehre zu gewährleisten, sind die verwendeten Methoden hier nachfolgend angegeben.

In allen Beispielen beziehen sich die Angaben von Teilen und Prozentsätzen auf das Gewicht, falls nicht anders angegeben.

### Viskosität:

Die Viskositäten werden, wenn nicht anders angegeben, durch rotationsviskosimetrische Messung gemäß DIN EN ISO 3219 bestimmt. Falls nicht anders angegeben, gelten alle Viskositätsangaben bei 25°C und Normaldruck von 1013 mbar.

### Brechungsindex:

Die Brechungsindices werden im Wellenlängenbereich des sichtbaren Lichtes bestimmt, falls nicht anders angegeben, bei 589 nm bei 25°C und Normaldruck von 1013 mbar gemäß der Norm DIN 51423.

### Transmission:

Die Transmission wird durch UV VIS Spektroskopie bestimmt. Ein geeignetes Gerät ist beispielsweise das Analytik Jena Specord 200.

Die verwendeten Messparameter sind: Bereich: 190 - 1100 nm Schrittweite: 0,2 nm, Integrationszeit: 0,04 s, Messmodus: Schrittbetrieb. Als erstes erfolgt die Referenzmessung (Background). Eine Quarzplatte, befestigt an einem Probenhalter (Dimension der Quarzplatten: HxB ca. 6 x 7 cm, Dicke ca. 2,3 mm), wird in den Probenstrahlengang gegeben und gegen Luft gemessen.

Danach erfolgt die Probenmessung. Eine am Probenhalter befestigte Quarzplatte mit aufgetragener Probe - Schichtdicke aufgetragene Probe ca. 1 mm - wird in den Probenstrahlengang gegeben und gegen Luft gemessen. Die interne Verrechnung gegen das Backgroundspektrum liefert das Transmissionsspektrum der Probe.

### Molekülzusammensetzungen:

Die Molekülzusammensetzungen werden mittels Kernresonanzspektroskopie bestimmt (zu Begrifflichkeiten siehe ASTM E 386: Hochauflösende magnetische Kernresonanzspektroskopie (NMR): Begriffe und Symbole), wobei der ¹H-Kern und der ²⁹Si-Kern vermessen werden.

### Beschreibung ¹H-NMR Messung

| | |
|---|---|
| Solvent: | CDCl3, 99,8%d |
| Probenkonzentration: | ca. 50 mg / 1 ml CDCl3 in 5 mm NMR-Röhrchen |

Messung ohne Zugabe von TMS, Spektrenreferenzierung von Rest-CHCl3 in CDCl3 auf 7,24 ppm

| | |
|---|---|
| Spektrometer: | Bruker Avance I 500 oder Bruker Avance HD 500 |
| Probenkopf: | 5 mm BBO-Probenkopf oder SMART-Probenkopf (Fa.Bruker) |

### Meßparameter:

Pulprog = zg30
TD = 64k
NS = 64 bzw. 128 (abhängig von der Empfindlichkeit des Probenkopfes)
SW = 20,6 ppm
AQ = 3,17 s
D1 = 5 s
SFO1 = 500,13 MHz
O1 = 6,175 ppm

### Processing-Parameter:

SI = 32k
WDW = EM
LB = 0,3 Hz

Je nach verwendetem Spektrometertyp sind evtl. individuelle Anpassungen der Messparameter erforderlich.

### Beschreibung ²⁹Si-NMR Messung

| | |
|---|---|
| Solvent: | C6D6 99,8%d/CCl4 1:1 v/v mit 1Gew% Cr(acac)₃ als Relaxationsreagenz |
| Probenkonzentration: | ca. 2 g / 1,5 ml Solvent in 10 mm NMR-Röhrchen |
| Spektrometer: | Bruker Avance 300 |
| Probenkopf: | 10 mm 1H/13C/15N/29Si glasfreier QNP-Probenkopf (Fa. Bruker) |

### Messparameter:

Pulprog = zgig60
TD = 64k
NS = 1024 (abhängig von der Empfindlichkeit des Probenkopfes)
SW = 200 ppm
AQ = 2,75 s
D1 = 4 s
SFO1 = 300,13 MHz
O1 = -50 ppm

### Processing-Parameter:

SI = 64k
WDW = EM
LB = 0,3 Hz

Je nach verwendetem Spektrometertyp sind evtl. individuelle Anpassungen der Messparameter erforderlich.

### Molekulargewichtsverteilungen:

Molekulargewichtsverteilungen werden als Gewichtsmittel Mw und als Zahlenmittel Mn bestimmt, wobei die Methode der Gelpermeationschromatographie (GPC bzw. Size Exclusion Chromatographie (SEC)) Anwendung findet mit Polystyrol Standard und Brechungsindexdetektor (RI-Detektor). Wo nicht anders ausgewiesen, wird THF als Eluent verwendet und DIN 55672-1 angewendet. Die Polydispersität ist der Quotient Mw/Mn.

### Bestimmung der dielektrischen Eigenschaften: Df, Dk

Die Bestimmung der dielektrischen Eigenschaften erfolgt gemäß IPC TM 650 2.5.5.13 mit einem Network Analyzer Keysight/ Agilent E8361A nach der Split-Cylinder Resonator Methode bei 10 GHz.

**Synthesebeispiel 1:** Herstellung einer Organopolysiloxanverbindung der Formel (I): Synthese nachgestellt gemäß DE 102005040323, Beispiel 1, führt zum dort beschriebenen Ergebnis:
Ein Gemisch aus 109 g redestilliertem 1,2-Bis(methyldichlor-silyl)ethan und 820 g Vinyldimethylchlorsilan wird auf 10°C gekühlt. Unter Rühren und gleichzeitigem Kühlen werden in ca. 80 Minuten insgesamt 1,7 l 5 %ige HCl-Lösung so zudosiert, dass die Temperatur des Reaktionsgemisches bei 10 - 20°C gehalten werden kann. Danach wird 30 Minuten lang kräftig gerührt, anschließend die Phasen separiert. Die Siloxanphase wird viermal mit je 1 1 Wasser gewaschen, mit 0,5 l 5%-iger NaHCO₃-Lösung neutralisiert und erneut mit 1 1 Wasser nachgewaschen. Flüchtige Hydrolyseprodukte werden im Vakuum bis 80°C abgetrennt (hauptsächlich Divinyltetramethyldisiloxan). Man erhält 149,8 g einer klaren Flüssigkeit als Rückstand, die eine Viskosität von 7,2 mm²/s (25°C) hat und mit einer Jodzahl von 169,6 genau eine C=C-Doppelbindung pro 149,8 g aufweist.

Das Verhältnis von Endgruppen/Verzweigungseinheit beträgt 2,57. Das Produkt enthält ca. 90 % des eingesetzten 1,2-Bis(methyldichlorsilyl)ethans in hydrolysierter Form.

### Synthesebeispiel 2: Herstellung einer silphenylenverbrückten Organopolysiloxanverbindung der Formel (I).

### Synthese der Silphenylenvorstufe:

1,4-Bis(dimethoxyphenylsilyl)benzol gemäß Literaturvorschrift nach Xunjun Chen, Minghao Yi, Shufang Wu, Lewen Tan, Yixin Xu, Zhixing Guan, Jianfang Ge and Guoqiang Yin: Synthesis of Silphenylene-Containing Siloxane
Resins Exhibiting Strong Hydrophobicity and High Water Vapor Barriers, Coatings 2019, 9, 481; doi:10.3390/coatings9080481 www.mdpi.com/journal/coatings
1,4-Bis(dimethoxyphenylsilyl)benzol wird erhalten, indem gemäß angegebener Literaturvorschrift gemäß "2.2. Synthesis of the 1,4-Bis(Dimethoxyphenylsilyl)Benzene (BDMPD)" Trimethoxyphenylsilan mit einem Grignard Reagenz erhalten aus 1,4-Dibrombenzol umgesetzt wird. Die Struktur wurde durch ¹H-NMR-Spektroskopie und Vergleich mit der angegebenen Literatur bestätigt.

Eine Mischung aus 845,2 g (= 4 mol) Phenyltrichlorsilan, 546,7 g (1,3 mol) 1,4-Bis(dimethoxyphenylsilyl)benzol, 198,7 g (0,8 mol) 3-(Trimethoxysilyl)propylmethacrylat und 820 g Xylol wird innerhalb von 4 Stunden in eine Vorlage aus 2400 g vollentsalztem Wasser dosiert. Die Vorlage besitzt zu Beginn der Dosierung Raumtemperatur von 23°C. Die Temperatur steigt aufgrund der exothermen Wärmeentwicklung der Reaktion an. Die Dosierung wird so gesteuert, dass die Innentemperatur im Reaktionsgefäß zu keiner Zeit höher als 50°C steigt. Gegebenenfalls wird die Dosiergeschwindigkeit reduziert.

Man rührt nach beendeter Dosierung 15 min nach. Anschließend wird der Rührer abgeschaltet. Die organische und die wässrige Phase trennen sich. Die untere, wässrige, klare und farblose Phase im Wesentlichen bestehend aus einer konzentrierten wässrigen Salzsäurelösung wird abgelassen.

Man gibt zur organischen Phase, die im Reaktionsgefäß verblieben ist, 1 1 vollentsalztes Wasser hinzu und vermischt unter Rühren. Nach 30 min schaltet man den Rührer ab und lässt die Phasen erneut trennen. Die wässrige Phase setzt sich unten ab und wird abgelassen. Sollte sich die wässrige Phase nach oben absetzen, wird statt mit vollentsalztem Wasser mit einer 10% Natriumchlorid haltigen wässrigen Lösung gewaschen, bzw. 100 g Natriumchlorid zugegeben, erneut für 30 min und danach die Phasentrennung erneut durchgeführt. Dieser Vorgang wird solange wiederholt, bis der Rest HCl-Gehalt in der organischen Phase unter 20 ppm beträgt. Der Rest HCl Gehalt wird durch eine Säure Base Titration gemäß Stand der Technik bestimmt. In der Regel reichen zwei Waschungen mit vollentsalztem Wasser oder 10%-iger wässriger NaCl Lösung aus. Anschließend wird Wasser mit Xylol als Wasserschlepper bei 110°C ausgekreist, bis kein Wasser mehr erhalten wird.

Das erhaltene Produkt enthält in diesem Stadium der Synthese ca. 3 Gewichtsprozent Silanolgruppen, die aufgrund ihrer Polarität in der Zielanwendung stören. Um den Silanolgehalt zu reduzieren wird folgende Vorgehensweise angewendet:
Man dosiert 200 g Wasser zu der zuvor ausdestillierten xylolischen Reaktionsmischung. Danach werden 265,1 g (2,2 mol) Vinyldimethylchlorsilan langsam zudosiert, wobei man die Dosiergeschwindigkeit so anpasst, dass die Reaktionstemperatur (Innentemperatur im Reaktionsgefäß) auf unter 50°C begrenzt bleibt. Nach beendeter Dosierung wird 60 min nachgerührt,
wobei weder geheizt noch gekühlt wird, um die Reaktion der Silanolgruppen mit dem Vinyldimethylchlorsilan bzw. dem Tetramethyldivinyldisiloxan, das sich daraus gebildet hat, vollständig abzuschließen.

Die Wasserphase wird wie oben beschrieben abgetrennt und danach dreimal jeweils mit einem Liter Wasser wir bereits oben beschrieben gewaschen. Gegebenenfalls kann die Phasentrennung verbessert werden, indem man bei abgeschaltetem Rührer auf 60°C Heizmanteltemperatur aufheizt. Nach den Waschungen beträgt der HCl-Gehalt in der xylolischen Lösung weniger als 20 ppm.

Man reduziert die Menge Xylol durch Destillation im Vakuum (20 mbar) bei 110°C soweit, dass eine Lösung aus 80% Harz in 20% Xylol erhalten wird.

In dem erhaltenen Produkt sind per ¹H-NMR keine Methoxygruppen mehr nachweisbar. D.h. das methacrylatfunktionelle Trimethoxysilan ist vollständig einkondensiert, das resultierende Methanol wurde bei der Aufarbeitung entfernt. Der Anteil an Silanolgruppen konnte durch die Nachbehandlung auf ca. 0,9 Gewichtsprozent (Bestimmung per ¹H-NMR) reduziert werden.

Per SEC (Eluent Toluol) wurden folgende Molekulargewichte bestimmt: Mw = 7347 g/mol, Mn = 2903 g/mol, Polydispersität PD = 2,53.

Nach ²⁹Si-NMR ist die molare Zusammensetzung des siliziumhaltigen Anteils der Zubereitung:
Me₂Si(Vi)O_{1/2}: 11,54 %
H_{2C}=C(CH₃)C(=O)-O-(CH₂)₃-SiO_{3/2}: 11,98%
O_{2/2}(Ph)Si-C₆H₄-Si(Ph)O_{2/2}: 19,23%
PhSiO_{3/2}: 57,25 %

Die Silanolgruppen finden sich an den PhSiO_{3/2}-Einheiten gebunden.

### Synthesebeispiel 3: Herstellung einer Organopolysiloxanverbindung der Formel (I)mit Phenylenbrücke.

Die Synthese gemäß Synthesebeispiel 2 wird wiederholt, wobei im Unterschied zu Synthesebeispiel 2 folgende Einsatzmengen verwendet werden:
Phenyltrichlorsilan: 281,7 g (= 1,3 mol)
1,4-Bis(dimethoxyphenylsilyl)benzol: 1202,7 g (2,9 mol)

Die übrige Ausführung entspricht der von Synthesebeispiel 3. Es wird folgendes Ergebnis erhalten:
Methoxygruppen sind im NMR nicht nachweisbar. Der Rest Silanolgehalt beträgt 0,8 Gewichtsprozent.

SEC: Mw = 8347 g/mol, Mn = 3953 g/mol, Polydispersität PD = 2,11.

Nach ²⁹Si-NMR ist die molare Zusammensetzung des siliziumhaltigen Anteils der Zubereitung:
Me₂Si(Vi)O_{1/2}: 10,93 %
H₂C=C(CH₃)C(=O)-O-(CH₂)₃-SiO_{3/2}: 10,89%
O_{2/2}(Ph)Si-C₆H₄-Si(Ph)O_{2/2}: 49, 96%
PhSiO_{3/2}: 28,22 %

### Synthesebeispiel 4: Herstellung einer Organopolysiloxanverbindung der Formel (I)mit Alkylenbrücke.

Die Synthese gemäß Synthesebeispiel 2 wird wiederholt, wobei im Unterschied zu Synthesebeispiel 2 folgende Einsatzmengen verwendet werden:
Phenyltrichlorsilan: 422,6 g (= 2 mol)
1,2-Bis(dichlormethylsilyl)ethan: 341,35 g (1,35 mol)
Vinyldimethylchlorsilan: 403,7 g (3,35 mol)

Es wird kein 1,4-Bis(dimethoxyphenylsilyl)benzol eingesetzt.

Bei dieser Synthese werden 271,2 g (2,25 mol) Vinyldimethylchlorsilan direkt in die Chlorsilanmischung gegeben, die im ersten Schritt in die Wasservorlage dosiert wird. Die verbleibenden 132,6 g (1,1 mol) werden wie in Synthesebeispiel 3 zur Reduzierung der Silanolgruppen verwendet.

Die übrige Ausführung entspricht der von Synthesebeispiel 3. Es wird folgendes Ergebnis erhalten:
Methoxygruppen sind im NMR nicht nachweisbar. Der Rest Silanolgehalt beträgt 0,9 Gewichtsprozent.

SEC: Mw = 6974 g/mol, Mn = 2812 g/mol, Polydispersität PD = 2,48.

Nach ²⁹Si-NMR ist die molare Zusammensetzung des siliziumhaltigen Anteils der Zubereitung:
Me₂Si(Vi)O_{1/2}: 50, 39 %
O_{2/2}(Me)Si-C₂H₄-Si(Me)O_{2/2}: 19, 56%
PhSiO_{3/2}: 30,05 %

### Synthesebeispiel 5: Herstellung einer Organopolysiloxanverbindung der Formel (I) mit Alkylen- und Phenylenbrücken.

Die Synthese gemäß Synthesebeispiel 2 wird wiederholt, wobei im Unterschied zu Synthesebeispiel 2 folgende Einsatzmengen verwendet werden:
Phenyltrichlorsilan: 422,6 g (= 2 mol)
1,2-Bis(dichlormethylsilyl)ethan: 512,0 g (2 mol)
1,4-Bis(dimethoxyphenylsilyl)benzol: 986,2 g (2,4 mol)
Vinyldimethylchlorsilan: 403,7 g (3,35 mol)

Bei dieser Synthese werden 271,2 g (2,25 mol) Vinyldimethylchlorsilan direkt in die Chlorsilanmischung gegeben, die im ersten Schritt in die Wasservorlage dosiert wird. Die verbleibenden 132,6 g (1,1 mol) werden wie in Synthesebeispiel 3 zur Reduzierung der Silanolgruppen verwendet.

Die übrige Ausführung entspricht der von Synthesebeispiel 3. Es wird folgendes Ergebnis erhalten:
Methoxygruppen sind im NMR nicht nachweisbar. Der Rest Silanolgehalt beträgt 0,9 Gewichtsprozent.

SEC: Mw = 4974 g/mol, Mn = 1966 g/mol, Polydispersität PD = 2,53.

Nach ²⁹Si-NMR ist die molare Zusammensetzung des siliziumhaltigen Anteils der Zubereitung:
Me₂Si(Vi)O_{1/2}: 34,49 %
O_{2/2}(Me)Si-C₂H₄-Si(Me)O_{2/2}: 20, 31%
O_{2/2}(Ph)Si-C₆H₄-Si(Ph)O_{2/2}: 24, 64%
PhSiO_{3/2}: 20,56 %

### Synthesebeispiel 6: Herstellung einer Organopolysiloxanverbindung der Formel (I) mit Alkylen- und Phenylenbrücke.

Die Synthese gemäß Synthesebeispiel 6 wird wiederholt, wobei im Unterschied zu Synthesebeispiel 6 folgende Einsatzmengen verwendet werden:
1,2-Bis(trimethoxysilyl)ethan: 540,0 g (2 mol)

Es wird in diesem Beispiel kein 1,2-Bis(dichlormethylsilyl)-ethan verwendet.

Die übrige Ausführung entspricht der von Synthesebeispiel 6. Es wird folgendes Ergebnis erhalten:
Methoxygruppen sind im NMR nicht nachweisbar. Der Rest Silanolgehalt beträgt 0,8 Gewichtsprozent.

SEC: Mw = 5768 g/mol, Mn = 2074 g/mol, Polydispersität PD = 2,78.

Nach ²⁹Si-NMR ist die molare Zusammensetzung des siliziumhaltigen Anteils der Zubereitung:
Me₂Si(Vi)O_{1/2}: 32,78 %
O_{3/2}Si-C₂H₄-SiO_{3/2}: 21,01%
O_{2/2}(Ph)Si-C₆H₄-Si(Ph)O_{2/2}: 23,48%
PhSiO_{3/2}: 22,73 %

### Synthesebeispiel 7: Herstellung einer Organopolysiloxanverbindung der Formel (I) mit Alkylenbrücke.

Die Synthese gemäß Synthesebeispiel 6 wird wiederholt, wobei im Unterschied zu Synthesebeispiel 6 folgende Einsatzmengen verwendet werden:
1,2-Bis(chlordimethylsilyl)ethan: 580,6 g (2,7 mol)

Es wird kein 1,2-Bis(dichlormethylsilyl)ethan verwendet.

Es wird kein 3-(Trimethoxysilyl)propylmethacrylat verwendet. Die übrige Ausführung entspricht der von Synthesebeispiel 3. Es wird folgendes Ergebnis erhalten:
Methoxygruppen sind im NMR nicht nachweisbar. Der Rest Silanolgehalt beträgt 0,8 Gewichtsprozent.

SEC: Mw = 5637 g/mol, Mn = 1964 g/mol, Polydispersität PD = 2,87.

Nach ²⁹Si-NMR ist die molare Zusammensetzung des siliziumhaltigen Anteils der Zubereitung:
Me₂Si(Vi)O_{1/2}: 11,96 %
O_{1/2}(Me₂)Si-C₂H₄-Si(Me₂)O_{1/2}: 19, 56%
PhSiO_{3/2}: 68,48 %

### Vergleichsbeispiel 1: nicht erfindungsgemäße Organopolysiloxansynthese ohne verbrückende Si-C-gebundene Einheiten

Die Synthesen gemäß der Synthesebeispiele 2, 3 und 4 werden wiederholt, wobei im Unterschied zu den Synthesebeispielen 2 - 4 keine Rohstoffe mit verbrückenden Einheiten verwendet werden. D.h. es wird kein 1,4-Bis(dimethoxyphenylsilyl)benzol und kein 1,2-Bis(dichlormethylsilyl)ethan verwendet.

Die Mengen, die für diese Rohstoffe angegeben sind, werden wie folgt ersetzt:
In Synthesebeispiel 2 wird kein 1,4-Bis(dimethoxyphenylsilyl)-benzol verwendet und die Synthese ansonsten wie angegeben unverändert durchgeführt.

### Ergebnis: Produktbezeichnung V1.2

Rest Methoxygehalt im 1H-NMR nicht nachweisbar. Der Silanolgehalt beträgt 1,1 Gewichtsprozent.

Per SEC (Eluent Toluol) wurden folgende Molekulargewichte bestimmt: Mw = 3657 g/mol, Mn = 1759 g/mol, Polydispersität PD = 2,07.

Nach ²⁹Si-NMR ist die molare Zusammensetzung des siliziumhaltigen Anteils der Zubereitung:
Me₂Si(Vi)O_{1/2}: 14,96 %
H₂C=C(CH₃)C(=O)-O-(CH₂)₃-SiO_{3/2}: 15,81%
PhSiO_{3/2}: 69,23 %

In Synthesebeispiel 3 wird die angegebene Menge 1,4-Bis(dime-thoxyphenylsilyl)benzol molar äquivalent durch Phenyltrichlorsilan ersetzt. Alle anderen Angaben bleiben unverändert.

### Ergebnis: Produktbezeichnung V1.3

Methoxygruppen sind im NMR nicht nachweisbar. Der Rest Silanolgehalt beträgt 1,0 Gewichtsprozent.

SEC: Mw = 3477 g/mol, Mn = 1385 g/mol, Polydispersität PD = 2,51.

Nach ²⁹Si-NMR ist die molare Zusammensetzung des siliziumhaltigen Anteils der Zubereitung:
Me₂Si(Vi)O_{1/2}: 11,03 %
H₂C=C(CH₃)C(=O)-O-(CH₂)₃-SiO_{3/2}: 11,36%
PhSiO_{3/2}: 77,61 %

In Synthesebeispiel 4 wird die angegebene Menge 1,4-Bis(dime-thoxyphenylsilyl)benzol molar äquivalent durch Phenyltrichlorsilan ersetzt. Alle anderen Angaben bleiben unverändert.

### Ergebnis: Produktbezeichnung V1.4

Methoxygruppen sind im NMR nicht nachweisbar. Der Rest Silanolgehalt beträgt 0,9 Gewichtsprozent.

SEC: Mw = 1576 g/mol, Mn = 885 g/mol, Polydispersität PD = 1,78.

Nach ²⁹Si-NMR ist die molare Zusammensetzung des siliziumhaltigen Anteils der Zubereitung:
Me₂Si(Vi)O_{1/2}: 51,35 %
PhSiO_{3/2}: 48,65 %

**Anwendungsbeispiel 1: Verwendung der Organopolysiloxane gemäß Synthesebeispiele 1 - 7 zur Herstellung metallkaschierter Laminate und Vergleich mit den Vergleichsbeispielen V1.2, V1.3 und V1.4.**

Die gemäß den Synthesebeispielen 1 bis 7 und gemäß dem Vergleichsbeispiel hergestellten Organopolysiloxane wurden als Bindemittel verwendet, um kupferkaschierte Laminate mit einer glasfaserverstärkten Composite Schicht herzustellen. Folgende Einsatzstoffe wurden verwendet:
Kupferfolie: 35 µm dicke Kupferfolie (285 ± 10 g/m²) der Firma Jiangtong-yates Copper Foil Co Ltd, mit einer Rautiefe von Rz ≤ 8 µm und einer Mittenrautiefe von Ra ≤ 0,4 µm, Reinheit ≥ 99,8%.

Glasfaser: E-Glasfaser Type 1080 E hergestellt von Changzhou Xingao Insulation Materials Co. Ltd. Dicke 0,055 ± 0,012 mm, 47,5 ± 2,5 g/m².

In diesem Beispiel wurde das Organopolysiloxan aus Synthesebeispiel 1 lösemittelfrei eingesetzt, alle anderen wurden als Lösung in Xylol verwendet. Die Lösungen enthielten für die Organopolysiloxane aus den Synthesebeispielen 4, 5, 6 und 7 und dem Vergleichsbeispiel V1.4 jeweils 90% Organopolysiloxan und 10% Xylol. Für die Organopolysiloxane aus den Synthesebeispielen 2 und 3 sowie dem Vergleichsbeispiel V1.2 und V1.3 wurden Zubereitungen aus 80% Organopolysiloxan und 20% Xylol verwendet.

Um die Härtung zu initiieren wurden die Organopolysiloxane mit jeweils 1 Gewichtsprozent Dicumylperoxid versetzt, das durch Rühren gleichmäßig in der Harzmatrix verteilt wurde.

Laminate wurden hergestellt, indem 30 x 30 cm große Glasfaserschichten lagenweise mit dem jeweiligen Organopolysiloxan gegebenenfalls als xylolische Lösung mithilfe einer Entlüfterrolle blasenfrei imprägniert wurden. Die Glasfaserschichten wurden dabei auf einer formstabilen ebenen Unterlage aus Edelstahl gelagert, auf die eine Lage Kupferfolie aufgebracht wurde, bevor die erste Lage Glasfaser aufgelegt wurde. Insgesamt wurden jeweils 3 Lagen Glasfasergewebe nacheinander imprägniert. Um das Lösemittel gegebenenfalls zu entfernen wurden die imprägnierten Gewebe bei 60°C in einem Vakuumtrockenschrank bei 10 mbar bis zur Gewichtskonstanz getrocknet. Danach wurde eine zweite Schicht Kupferfolie auf die imprägnierte Glaserfaserschicht oben aufgebracht und eine weitere formstabile Edelstahlplatte aufgelegt. Das Laminat wurde in einer heizbaren Presse bei 2 MPa Druck, 120 min bei 200°C und 30 mbar Unterdruck ausgeheizt. Man erhält kupferkaschierte Laminate mit einer Gesamtdicke von 260 ± 20 µm.

Die dielektrischen Eigenschaften wurden bestimmt gemäß IPC TM 650 2.5.5.13 mit einem Network Analyzer Keysight/Agilent E8361A nach der Split-Cylinder Resonator Methode bei 10 GHz. Die in Tabelle 1 angegebenen Werte wurden erhalten:

| Organopolysiloxan aus | Dₖ | D_{f} |
|---|---|---|
| Synthesebeispiel 1 | 2,76 | 0,0022 |
| Synthesebeispiel 2 | 2, 98 | 0,0027 |
| Synthesebeispiel 3 | 2, 67 | 0,0029 |
| Synthesebeispiel 4 | 2,76 | 0,0023 |
| Synthesebeispiel 5 | 2, 89 | 0,0028 |
| Synthesebeispiel 6 | 2,84 | 0,0025 |
| Synthesebeispiel 7 | 2,56 | 0,0026 |
| Vergleichsbeispiel V1.2* | 3,36 | 0,0045 |
| Vergleichsbeispiel V1.3* | 3,25 | 0,0049 |
| Vergleichsbeispiel V1.4* | 3,29 | 0,0048 |

| | | |
|---|---|---|
| *nicht erfindungsgemäß | | |

Die erzielten Dₖ und D_{f} Werte der kupferkaschierten Laminate aus den Organopolysiloxanverbindungen der Formel (I)sind deutlich niedriger als die D_{f} und Dₖ-Werte, die mit den Organopolysiloxanen aus den Vergleichsbeispielen erzielt werden. Da für Hochfrequenzanwendungen möglichst niedrige dielektrische Verlustfaktoren und Dielektrizitätszahlen angestrebt werden, ist der erfindungsgemäße Effekt deutlich zu erkennen.

**Anwendungsbeispiel 2 Verwendung der Organopolysiloxane gemäß Synthesebeispiele 1 - 7 und der Organopolysiloxane gemäß des Vergleichsbeispiels 1 zur Herstellung metallkaschierter Laminate unter Einsatz von Füllstoff.**

Im Unterschied zu Anwendungsbeispiel 1 wurden jeweils 49,5% Fällungskieselsäure vom Typ Q 033 (Hersteller Suzhou Ginet New Materials Technology Co Ltd, sphärische Siliziumdioxid Partikel, D₉₉ ≤ 3 µm, SiO₂ ≥ 99%) in die Harze und Harzlösungen unter Verwendung eines handelsüblichen Dissolvers homogen eingearbeitet. Für die Harzzubereitungen, in denen in Anwendungsbeispiel 1 Xylol verwendet wurde, wurden statt 10 und 20% Xylol jeweils 30 und 40% Xylol verwendet.

Anstatt das Laminat ohne eine Prepreg Zwischenstufe direkt aufzubauen, wurden diesmal Prepregs hergestellt, indem die Glasfaserlagen als einzelne Lagen jeweils auf einer Polytetrafluorethylenfolie mit der Harzzubereitung imprägniert und anschließend im Vakuumtrockenschrank zur Gewichtskonstanz getrocknet wurden. Jeweils drei auf diese Weise hergestellte Lagen aus imprägniertem Glasfasergewebe wurden anschließend auf eine Kupferfolie übereinander abgelegt und der Stapel mit einer Lage Kupferfolie abgeschlossen. Dieser Mehrschichtaufbau wurde analog zu Anwendungsbeispiel 1 zwischen zwei formstabilen Edelstahlplatten in einer vakuumpresse unter den Bedingungen wie in Beispiel 1 angegeben verpresst und ausgehärtet.

Die erhaltenen Laminate wiesen Dicken von 290 ± 20 µm auf.

An den erhaltenen Laminaten wurden die in Tabelle 2 angegebenen dielektrischen Eigenschaften gemessen:

| Organopolysiloxan aus | Dₖ | D_{f} |
|---|---|---|
| Synthesebeispiel 1 | 2,96 | 0,0031 |
| Synthesebeispiel 2 | 2,92 | 0,0033 |
| Synthesebeispiel 3 | 2,79 | 0,0034 |
| Synthesebeispiel 4 | 2,99 | 0,0030 |
| Synthesebeispiel 5 | 3,00 | 0,0034 |
| Synthesebeispiel 6 | 2,89 | 0,0032 |
| Synthesebeispiel 7 | 3,05 | 0,0035 |
| Vergleichsbeispiel V1.2* | 3,56 | 0,0060 |
| Vergleichsbeispiel V1.3* | 3,54 | 0,0063 |
| Vergleichsbeispiel V1.4* | 3,50 | 0,0066 |

| | | |
|---|---|---|
| *nicht erfindungsgemäß | | |

Die Erhöhung der Dk und Df Werte wird zusätzlichen Polarisierungseffekten an den Grenzflächen zwischen der Fällungskieselsäure und den Organopolysiloxanen zugeschrieben. Die erfindungsgemäße Herstellung metallkaschierter Laminate mit einer Organopolysiloxanverbindung der Formel (I) gelingt allerdings auch in diesem Falle und der Vorteil gegenüber nicht erfindungsgemäßen Organopolysiloxanen ist auch in diesem Fall deutlich erkennbar.

### Anwendungsbeispiel 3: ausgewählte Synthesebeispiele mit höher viskosen und festen Materialien über Prepreg

Im Unterschied zu Anwendungsbeispiel 2 wurde diesmal kein Füllstoff eingesetzt. Prepregs lassen sich unter diesen Umständen nur mit denjenigen Organopolysiloxanen herstellen, die ausreichend klebfrei auftrocknen. Für dieses Beispiel wurden daher nur die Organopolysiloxane aus den Synthesen Beispielen 2 bis 7 und die Organopolysiloxane V1.2 und V1.3 aus dem Vergleichsbeispiel 1 verwendet. Sie wurden mit 10 und 20% Xylol verdünnt verwendet, wie in Anwendungsbeispiel 1 angegeben. Das Organopolysiloxan aus Synthesebeispiel 1 ist trotzdem erfindungsgemäß, denn die Möglichkeit der Herstellung eines klebfreien Prepregs ist auch dann erfüllt, wenn dies durch geeignete Maßnahmen gelingt, wie beispielsweise das Füllen mit geeigneten Füllstoffen oder das Abmischen mit anderen Organopolysiloxanen oder geeigneten organischen Polymeren. Da dies Maßnahmen zur Erstellung von Formulierungen gemäß Stand der Technik zur Herstellung von Bindemittelformulierungen für metallkaschierte Laminate sind, steht die Klebrigkeit eines Prepregs hergestellt aus einer reinen Organopolysiloxanverbindungen der Formel (I) ohne weitere Formulierungsmaßnahmen nicht im Widerspruch zum Erfindungsgegenstand.

Ansonsten entspricht die Vorgehensweise der in Anwendungsbeispiel 2 beschriebenen.

Die erhaltenen Laminate wiesen Dicken von 270 ± 20 µm auf.

An den erhaltenen Laminaten wurden die in Tabelle 3 angegebenen dielektrischen Eigenschaften gemessen:

| Organopolysiloxan aus | Dₖ | D_{f} |
|---|---|---|
| Synthesebeispiel 2 | 2,96 | 0,0025 |
| Synthesebeispiel 3 | 2,70 | 0,0026 |
| Synthesebeispiel 4 | 2,70 | 0,0025 |
| Synthesebeispiel 5 | 2,85 | 0,0026 |
| Synthesebeispiel 6 | 2,82 | 0,0023 |
| Synthesebeispiel 7 | 2,55 | 0,0027 |
| Vergleichsbeispiel V1.2* | 3,38 | 0,0049 |
| Vergleichsbeispiel V1.3* | 3,30 | 0,0050 |

| | | |
|---|---|---|
| *nicht erfindungsgemäß | | |

Die erzielten Dₖ und D_{f} Werte der kupferkaschierten Laminate aus den erfindungsgemäßen Organopolysiloxanen sind deutlich niedriger als die D_{f} und Dₖ-Werte, die mit den Organopolysiloxanen aus den Vergleichsbeispielen erzielt werden. Da für Hochfrequenzanwendungen möglichst niedrige dielektrische Verlustfaktoren und Dielektrizitätszahlen angestrebt werden, ist der erfindungsgemäße Effekt deutlich zu erkennen.

**Anwendungsbeispiel 4 Verwendung der Organopolysiloxane gemäß Synthesebeispiele 1 - 7 und dem Vergleichsbeispiel 1 im Gemisch mit organischen Polymeren zur Herstellung metallkaschierter Laminate.**

Die Vorgehensweise entspricht im Wesentlichen der in Anwendungsbeispiel 2 beschriebenen. Im Unterschied zu Anwendungsbeispiel 2 wurde kein Füllstoff verwendet.

Stattdessen wurde organische Polymere mit den Organopolysiloxanen gemischt. Die finalen lösemittelfreien Mischungen enthielten stets 30 Gewichtsprozent Organopolysiloxan und 70 Gewichtsprozent organische Polymere. Als organische Polymere wurden Triallylisocyanurat, NORYL SA 9000, ein alph omega methacrylatterminierter Polyphenylenether bezogen von der Firma SABIC, Mn = 2500 g/mol, Tg = 160°C und B 3000 der Firma Nippon Soda, ein flüssiges Polybutadien Mn = 3200, Viskosität bei 45°C = 210 Poise mit mehr als 85% 1,2-Vinylstruktur in der Polymerkette eingesetzt.

Die Polymere wurden stets im gleichen Mengenverhältnis verwendet. Sie wurden in Xylol gelöst bzw. dispergiert, wobei 30 Gewichtsteile SA 9000, 25 Gewichtsteile B 3000 und 15 Gewichtsteile Triallylisocyanurat mit 100 Gewichtsteilen Xylol dispergiert wurden.

Die so erhaltene Zubereitung wurde mit den Lösungen der Organopolysiloxane hergestellt gemäß Anwendungsbeispiel 2 so vermischt, dass jeweils das angegebene Mischungsverhältnis aus 30% Organopolysiloxan und 70% organische Komponenten in der erhaltenen Lösung vorlag. Diese Lösungen wurden dann verwendet, um wie in Anwendungsbeispiel 2 beschrieben Prepregs herzustellen.

Die erhaltenen Laminate wiesen Dicken von 290 ± 20 µm auf.

An den erhaltenen Laminaten wurden die in Tabelle 4 angegebenen dielektrischen Eigenschaften gemessen:

| mit den Organopolysiloxan aus | Dₖ | D_{f} |
|---|---|---|
| Synthesebeispiel 1* | 2,99 | 0,0029 |
| Synthesebeispiel 2 | 2,63 | 0,0022 |
| Synthesebeispiel 3 | 2,57 | 0,0024 |
| Synthesebeispiel 4 | 2,68 | 0,0021 |
| Synthesebeispiel 5 | 2,66 | 0,0023 |
| Synthesebeispiel 6 | 2,59 | 0,0022 |
| Synthesebeispiel 7 | 2,60 | 0,0023 |
| Vergleichsbeispiel V1.2* | 3,16 | 0,0040 |
| Vergleichsbeispiel V1.3* | 3,01 | 0,0041 |
| Vergleichsbeispiel V1.4* | 3,21 | 0,0042 |

| | | |
|---|---|---|
| *nicht erfindungsgemäß * Die Zubereitung aus Organopolysiloxan gemäß Synthesebeispiel 1 und den organischen Komponenten ist inhomogen, was in einer elektronenmikroskopischen Aufnahme anhand von Domänenbildung erkennbar ist. Eine Kompatibilitisierung wäre durch eine Erhöhung des siliziumgebundenen Phenylanteils erreichbar oder indem man im organischen Teil der Zubereitung den aromatischen Anteil reduziert. | | |

Die erzielten Dₖ und D_{f} Werte der kupferkaschierten Laminate unter Verwendung der erfindungsgemäßen Organopolysiloxanen sind deutlich niedriger als die D_{f} und Dₖ-Werte, die mit den Organopolysiloxanen aus den Vergleichsbeispielen erzielten. Da für Hochfrequenzanwendungen möglichst niedrige dielektrische Verlustfaktoren und Dielektrizitätszahlen angestrebt werden, ist der erfindungsgemäße Effekt deutlich zu erkennen.

## Patentansprüche

1. Metallplattierte Schichtstoffe, welche enthalten vernetzungsfähige Organopolysiloxanverbindungen der Formel (I)
[O_{3-a/2}RₐSi-Y(SiRₐO_{3-a/2})_{b}]_{c}(R¹SiO_{3/2})_{d}(R²₂SiO_{2/2})ₑ(R³₃SiO_{1/2})_{f}(SiO_{4/2})_{g} (I)
wobei R gleich oder verschieden sein kann und entweder einen Wasserstoffrest oder einen einwertigen Si-C gebundenen, gegebenenfalls mit Heteroatomen substituierten organischen Kohlenwasserstoffrest mit 1 bis 18 C-Atomen bedeutet,
Y einen zwei- bis zwölfbindigen gegebenenfalls mit Heteroatomen substituierten organischen Rest mit 1 bis 24 C-Atomen bedeutet, wobei der Rest Y stets durch eine Si-C-Bindung an die Siliziumatome gebunden vorliegt, die durch den Rest Y miteinander verbunden werden,
R¹ unabhängig voneinander einen Wasserstoffrest oder einen Si-C-gebundenen ungesättigten C1 - C18 Kohlenwasserstoffrest bedeutet, der gegebenenfalls mit Heteroatomen substituiert sein kann, der gegebenenfalls auch über ein Sauerstoffatom an das Siliziumatom gebunden vorliegen kann, wobei die Reste R¹ ihre Bedeutung jeweils unabhängig voneinander annehmen können, so dass mehrere Reste R¹ in dem Organopolysiloxan gemäß Formel (I), verschiedene Reste aus der definierten Gruppe bedeuten können
die Reste R² und R³ unabhängig voneinander einen Wasserstoffrest oder einen gegebenenfalls ungesättigten Si-C gebundenen C1 - C18 Kohlenwasserstoffrest, der gegebenenfalls mit Heteroatomen substituiert sein kann oder einen über ein Sauerstoffatom gebundenen C1 - C12 gegebenenfalls Heteroatome enthaltenden Kohlenwasserstoffrest bedeuten, wobei die Reste R² und die Reste R³ ihre Bedeutung jeweils unabhängig voneinander annehmen können, so dass mehrere Reste R² bzw. mehrere Reste R³, die am gleichen Siliziumatom gebunden vorliegen, verschiedene Reste aus der definierten Gruppe bedeuten können,
wobei bezogen auf alle Si-C-gebundenen Reste Y, R, R¹, R² und R³ als 100 mol-% mindestens 0,1 mol-%, aliphatisch ungesättigte Reste sein müssen,
a 0, 1 oder 2 ist, wobei die Indices a zu beiden Seiten der Gruppe Y ihre Bedeutung unabhängig voneinander annehmen können, so dass verschiedene a unabhängig voneinander verschiedene Werte innerhalb des angegebenen Wertebereiches bedeuten können,
b eine Zahl im Wert von 1 bis 11,
c einen Wert von 0,1 bis 0,99,
d einen Wert von 0 bis 0,8,
e einen Wert von 0 bis 0,5,
f einen Wert von 0,01 bis 0,6 und
g einen Wert von 0 bis 0,2 bedeutet, wobei
c+d+e+f+g = 1 ist.

2. Metallplattierte Schichtstoffe nach Anspruch 1, bei denen die Kohlenwasserstoffreste R, R¹, R² und R³ ausgewählt werden aus Methyl- Phenyl-, Vinyl-, Acryloyloxy- und Methacryloyloxyresten sowie den Acrylsäureestern oder Methacrylsäureestern von unverzweigten oder verzweigten Alkoholen mit 1 bis 15 C-Atomen.

3. Metallplattierte Schichtstoffe nach einem der vorangehenden Ansprüche, bei denen Y zwei-, drei- oder vierwertig ist.

4. Metallplattierte Schichtstoffe nach einem der vorangehenden Ansprüche, die Zubereitungen aufweisen, welche die Organopolysiloxanverbindungen der Formel (I) und weitere Bestandteile enthalten.

5. Metallplattierte Schichtstoffe nach Anspruch 4, bei denen die weiteren Bestandteile ausgewählt werden aus Hydrosilylierungskatalysator, Initiator für die radikalische Polymerisation, organische Bindemittel, Lösemittel, Formulierungskomponenten, Haftvermittler, Härtungsinitiatoren, Katalysatoren, Stabilisatoren, Füllstoffe, Inhibitoren, flammhemmende Additive, Vernetzungshilfsmittel, Antioxidationsmittel, Stabilisatoren gegen Abbau durch Bewitterung, Gleitmittel, Weichmacher, farbgebende Mittel, phosphoreszierende oder andere Mittel zum Zwecke der Markierung und Nachverfolgbarkeit und Antistatikmittel.

6. Metallplattierte Schichtstoffe, nach einem der vorangehenden Ansprüche, bei denen das Metall Kupfer ist.

## Claims

1. Metal-clad laminates comprising crosslinkable, organopolysiloxane compounds of the formula (I)
[O_{3-a/2}RₐSi-Y(SiRₐO_{3-a/2})_{b}]_{c}(R¹SiO_{3/2})_{d}(R²₂SiO_{2/2})ₑ(R³₃SiO_{1/2})_{f}(SiO_{4/2})_{g} (I)
where R may be identical or different and is either a hydrogen radical or a monovalent SiC-bonded organic hydrocarbon radical having 1 to 18 carbon atoms and optionally substituted with heteroatoms,
Y is a divalent to dodecavalent organic radical having 1 to 24 carbon atoms and optionally substituted with heteroatoms, where the radical Y is always attached by an Si-C bond to the silicon atoms connected to each other by the radical Y,
R¹ is independently of one another a hydrogen radical or an SiC-bonded unsaturated C1-C18 hydrocarbon radical that may optionally be substituted with heteroatoms and that optionally may also be attached to the silicon atom via an oxygen atom, where the radicals R¹ may each assume their meaning independently of one another, such that a plurality of radicals R¹ in the organopolysiloxane according to formula (I) may be different radicals from the defined group,
the radicals R² and R³ are independently of one another a hydrogen radical or an optionally unsaturated SiC-bonded C1-C18 hydrocarbon radical that may optionally be substituted with heteroatoms, or a C1-C12 hydrocarbon radical that optionally contains heteroatoms and is attached via an oxygen atom, where the radicals R² and the radicals R³ may each assume their meaning independently of one another, such that a plurality of radicals R² or a plurality of radicals R³ attached to the same silicon atom may be different radicals from the defined group,
where, based on all SiC-bonded radicals Y, R, R¹, R² and R³ as 100 mol%, at least 0.1 mol% must be aliphatically unsaturated radicals,
a is 0, 1 or 2, where the indices a on either side of the group Y may assume their meaning independently of one another, such that different a may independently of one another be different values within the range of values specified,
b is a number having a value from 1 to 11,
c is a value from 0.1 to 0.99,
d is a value from 0 to 0.8,
e is a value from 0 to 0.5,
f is a value from 0.01 to 0.6 and
g is a value from 0 to 0.2, where c+d+e+f+g is 1.

2. Metal-clad laminates according to Claim 1, in which the hydrocarbon radicals R, R¹, R² and R³ are selected from methyl, phenyl, vinyl, acryloyloxy and methacryloyloxy radicals and the acrylic esters or methacrylic esters of unbranched or branched alcohols having 1 to 15 carbon atoms.

3. Metal-clad laminates according to either of the preceding claims, in which Y is divalent, trivalent or tetravalent.

4. Metal-clad laminates according to any of the preceding claims, comprising formulations that contain organopolysiloxane compounds of the formula (I) and further constituents.

5. Metal-clad laminates according to Claim 4, in which the further constituents are selected from hydrosilylation catalyst, initiator for the free-radical polymerization, organic binders, solvents, formulation components, adhesion promoters, curing initiators, catalysts, stabilizers, fillers, inhibitors, flame-retardant additives, crosslinking aids, antioxidants, stabilizers against degradation due to weathering, lubricants, plasticizers, colourants, phosphorescent agents or other agents for the purposes of marking and traceability, and antistats.

6. Metal-clad laminates according to any of the preceding claims, in which the metal is copper.

## Revendications

1. Stratifiés plaqués de métal, qui contiennent des composés organopolysiloxane aptes à une réticulation de formule (I)
[O_{3-a/2}RₐSi-Y(SiRₐO_{3-a/2})_{b}]_{c}(R¹SiO_{3/2})_{d}(R²₂SiO_{2/2})ₑ(R³₃SiO_{1/2})_{f}(SiO_{4/2})_{g} (I)
dans laquelle R peut être identique ou différent et signifie soit un radical hydrogène, soit un radical hydrocarboné organique monovalent, lié par Si-C, le cas échéant substitué par des hétéroatomes, comprenant 1 à 18 atomes de carbone,
Y signifie un radical organique bivalent à dodécavalent, le cas échéant substitué par des hétéroatomes, comprenant 1 à 24 atomes de carbone, le radical Y se trouvant toujours sous forme liée, par une liaison Si-C, aux atomes de silicium qui sont reliés l'un à l'autre par le radical Y,
R¹ signifie, indépendamment, un radical hydrogène ou un radical hydrocarboné en C1-C18, lié par Si-C, insaturé, qui peut le cas échéant être substitué par des hétéroatomes, qui peut le cas échéant également se trouver sous forme liée, par l'intermédiaire d'un atome d'oxygène, à l'atome de silicium, les radicaux R¹ pouvant à chaque fois prendre leur signification indépendamment les uns des autres, de telle sorte que plusieurs radicaux R¹ dans l'organopolysiloxane selon la formule (I) peuvent signifier différents radicaux du groupe défini
les radicaux R² et R³ signifient, indépendamment l'un de l'autre, un radical hydrogène ou un radical hydrocarboné en C1-C18, le cas échéant insaturé, lié par Si-C, qui peut le cas échéant être substitué par des hétéroatomes ou un radical hydrocarboné en C1-C12 lié par un atome d'oxygène, contenant le cas échéant des hétéroatomes, les radicaux R² et les radicaux R³ pouvant à chaque fois prendre leur signification indépendamment les uns des autres, de telle sorte que plusieurs radicaux R² ou, le cas échéant, plusieurs radicaux R³, qui se trouvent sous forme liée au même atome de silicium, peuvent signifier différents radicaux du groupe défini,
où, par rapport à tous les radicaux Y, R, R¹, R² et R³ liés par Si-C valant 100% en mole, au moins 0,1% en mole doivent être des radicaux aliphatiquement insaturés,
a représente 0, 1 ou 2, les indices a sur les deux côtés du groupe Y pouvant prendre leur signification indépendamment les uns des autres, de telle sorte que différents a peuvent signifier, indépendamment les uns des autres, des valeurs différentes dans la plage de valeurs indiquée,
b signifie un nombre de valeur 1 à 11,
c signifie une valeur de 0,1 à 0,99,
d signifie une valeur de 0 à 0,8,
e signifie une valeur de 0 à 0,5,
f signifie une valeur de 0,01 à 0,6 et
g signifie une valeur de 0 à 0,2, où c+d+e+f+g = 1.

2. Stratifiés plaqués de métal selon la revendication 1, dans lesquels les radicaux hydrocarbonés R, R¹, R² et R³ sont choisis parmi les radicaux méthyle, phényle, vinyle, acryloyloxy et méthacryloyloxy ainsi que les esters de l'acide acrylique ou les esters de l'acide méthacrylique d'alcools linéaires ou ramifiés comprenant 1 à 15 atomes de carbone.

3. Stratifiés plaqués de métal selon l'une des revendications précédentes, dans lesquels Y est bivalent, trivalent ou tétravalent.

4. Stratifiés plaqués de métal selon l'une des revendications précédentes, qui présentent des compositions qui contiennent les composés organopolysiloxane de formule (I) et d'autres constituants.

5. Stratifiés plaqués de métal selon la revendication 4, dans lesquels les autres constituants sont choisis parmi les catalyseurs d'hydrosilylation, les initiateurs pour la polymérisation par voie radicalaire, les liants organiques, les solvants, les composants de formulation, les promoteurs d'adhérence, les initiateurs de durcissement, les catalyseurs, les stabilisants, les charges, les inhibiteurs, les additifs ignifuges, les adjuvants de réticulation, les antioxydants, les stabilisants contre la dégradation par les intempéries, les lubrifiants, les plastifiants, les agents colorants, les agents phosphorescents ou d'autres agents à des fins de marquage et de traçabilité et les agents antistatiques.

6. Stratifiés plaqués de métal selon l'une des revendications précédentes, dans lesquels le métal est le cuivre.
